# EUROPEAN PATENT APPLICATION

(11) **EP 4 615 172 A1**
(43) Date of publication of application: **10.09.2025**
(21) Application number: 23885885.6
(22) Date of filing: 02.11.2023
(51) Int. Cl.: H05K 1/11, H01G 4/10, H01G 4/33, H01L 23/12, H01L 23/15, H05K 3/14, H05K 3/18, H05K 3/40

(54) **THROUGH-HOLE ELECTRODE SUBSTRATE AND METHOD FOR MANUFACTURING THROUGH-HOLE ELECTRODE SUBSTRATE**

(30) Priority: 04.11.2022 JP 2022177663; 14.06.2023 JP 2023098105
(71) Applicant: Dai Nippon Printing Co., Ltd., Tokyo 162-8001 (JP)
(72) Inventor: SUZUKI Miyuki, Tokyo 162-8001 (JP); MORII Akio, Tokyo 162-8001 (JP); YOSHII Yumi, Tokyo 162-8001 (JP); ARAI Junko, Tokyo 162-8001 (JP); TSUNODA Tsuyoshi, Tokyo 162-8001 (JP); FUJIMOTO Koji, Tokyo 162-8001 (JP)
(74) Representative: Müller-Boré & Partner Patentanwälte PartG mbB
(86) International application number: PCT/JP2023/039769
(87) International publication number: WO 2024/096131

(57) **Abstract**

A through-via substrate includes a substrate that includes a first surface, a second surface positioned on an opposite side from the first surface, and a through hole penetrating from the first surface to the second surface, a metal layer including at least a hole metal layer positioned in the through hole, and an adhesion layer positioned between the substrate and the metal layer and including a metal oxide. The through hole includes a side wall extending from the first surface to the second surface. The side wall includes a first end connected to the first surface and a second end connected to the second surface. The adhesion layer includes a hole adhesion layer positioned between the side wall and the hole metal layer so as to extend from a first end of the side wall to a second end of the side wall.

## Description

### Technical Field

An embodiment of the present disclosure relates to a through-via substrate and a manufacturing method for a through-via substrate.

### Background Art

A member, so-called a through-via substrate, includes a substrate having a first surface and a second surface, through holes formed in the substrate, and through vias positioned in the through holes, and is used in various applications. For example, a through-via substrate is used as an interposer placed between two LSI chips when a plurality of LSI chips is stacked to increase the packing density of LSls. A through-via substrate can be placed between an element, such as an LSI chip, and a mounting substrate, such as a motherboard. A through-via substrate is also used as a member that constitutes a passive component, such as an inductor and a capacitor.

The problem that the through via peels off from the side wall of the through hole due to temperature changes or the like is known. To solve this problem, for example, PTL 1 proposes partially forming a bonding layer between the side wall of the through hole and the through via.

### Citation List

### Patent Literature

PTL 1: Japanese Unexamined Patent Application Publication No. 2022-519287

### Summary of Invention

The through via in PTL 1 includes a portion that is in contact with the side wall of the through hole. For this reason, there is a risk that the through via may peel off from the side wall of the through hole.

The embodiment of the present disclosure aims to provide a through-via substrate and a manufacturing method for a through-via substrate, which can effectively solve such a problem.

The embodiment of the present disclosure relates to the following [1] to [23].
[1] A through-via substrate includes:
   a substrate that includes a first surface, a second surface positioned on an opposite side from the first surface, and a through hole penetrating from the first surface to the second surface;
   a metal layer including at least a hole metal layer positioned in the through hole; and
   an adhesion layer positioned between the substrate and the metal layer, the adhesion layer including a metal oxide, wherein
   the through hole includes a side wall extending from the first surface to the second surface,
   the side wall includes a first end connected to the first surface and a second end connected to the second surface, and
   the adhesion layer includes a hole adhesion layer positioned between the side wall and the hole metal layer so as to extend from the first end of the side wall to the second end of the side wall.
[2] In the through-via substrate according to [1], the through hole may have an aspect ratio of 3.0 or greater. The aspect ratio is a ratio of a thickness of the substrate to a minimum value of a width of the through hole.
**[3]** In the through-via substrate according to [1] or [2], the metal oxide may be titanium oxide, zinc oxide, aluminum oxide, tantalum oxide, or magnesium oxide.
[4] In the through-via substrate according to any one of [1] to [3], the adhesion layer may include the metal oxide in a crystalline state.
[5] In the through-via substrate according to any one of [1] to [4], an electron diffraction pattern of the metal oxide of the adhesion layer may include a plurality of diffraction spots regularly arranged in at least one direction.
[6] In the through-via substrate according to any one of [1] to [5], the hole adhesion layer may have a central thickness at a central position in a thickness direction of the substrate and have an edge thickness at a position of the first surface of the substrate, and a ratio of the edge thickness to the central thickness may be 1.10 or less.
[7] In the through-via substrate according to any one of [1] to [6], the adhesion layer may include a lower adhesion layer that is in contact with the substrate and an upper adhesion layer that is in contact with the metal layer.
[8] In the through-via substrate according to any one of [1] to [7], the substrate may include a surface layer that constitutes a surface of the side wall, and the surface layer may include metal atoms that are the same as metal atoms that constitute the metal oxide of the adhesion layer.
[9] In the through-via substrate according to [8], the metal oxide included in the lower adhesion layer and the metal oxide included in the upper adhesion layer may be different from each other.
[10] In the through-via substrate according to any one of [1] to [9], the metal layer may include copper, aluminum, nickel, gold, or tungsten.
[11] In the through-via substrate according to any one of [1] to [10], the metal layer may include a body layer and an intermediate layer, the body layer may include a metal material, the intermediate layer may be positioned between the body layer and the adhesion layer, and the intermediate layer may include a metal material, and the intermediate layer may be thinner than the body layer.
[12] In the through-via substrate according to [11], the body layer and the intermediate layer may include the same metal material.
[13] In the through-via substrate according to any one of [1] to [12], the adhesion layer may include a first adhesion layer positioned on the first surface, and the metal layer may include a first metal layer positioned on the first adhesion layer.
[14] In the through-via substrate according to [13], the hole metal layer may have a central thickness at a central position in a thickness direction of the substrate, and a ratio of a thickness of the first metal layer to the central thickness of the hole metal layer may be 1.50 or less.
[15] The through-via substrate according to [13] or [14] may further include a first wiring layer that includes a first insulating layer partially covering the first metal layer and a first conductive layer connected to the first metal layer.
[16] In the through-via substrate according to [15], the first conductive layer may include copper, aluminum, nickel, gold, or tungsten.
[17] In the through-via substrate according to [15] or [16], the first insulating layer may include silicon oxide, silicon nitride, or polyimide.
[18] In the through-via substrate according to any one of [13] to [17], the adhesion layer may include a second adhesion layer positioned on the second surface, and the metal layer may include a second metal layer positioned on the second adhesion layer.
[19] The through-via substrate according to [18] may further include a second wiring layer that includes a second insulating layer partially covering the second metal layer and a second conductive layer connected to the second metal layer.
[20] The through-via substrate according to any one of [1] to [19] may further include a semiconductor element, a sensor, an optical component, or a high-frequency component.
[21] A manufacturing method for a through-via substrate includes:
   a preparation step of preparing a substrate that includes a first surface, a second surface positioned on an opposite side from the first surface, and a through hole penetrating from the first surface to the second surface;
   an adhesion layer formation step of forming an adhesion layer on a surface of the substrate; and
   a metal layer formation step of forming a metal layer on the adhesion layer, wherein
   the through hole includes a side wall extending from the first surface to the second surface,
   the side wall includes a first end connected to the first surface and a second end connected to the second surface,
   the adhesion layer formation step includes a deposition step of forming a hole adhesion layer by chemical vapor deposition, the hole adhesion layer being positioned between the side wall and the metal layer so as to extend from the first end of the side wall to the second end of the side wall, and
   the metal layer formation step includes a step of forming a hole metal layer on the hole adhesion layer, the hole metal layer being positioned in the through hole.
[22] In the manufacturing method for a through-via substrate according to [21], the metal layer formation step may include a step of forming an intermediate layer on the adhesion layer by electroless plating and a step of forming a body layer on the intermediate layer by electrolytic plating.
[23] In the manufacturing method for a through-via substrate according to [21] or [22], the deposition step may be performed in an environment of 100°C or higher.
[24] In the manufacturing method for a through-via substrate according to any one of [21] to [23], the adhesion layer formation step may include an annealing step of, after the deposition step, heating the adhesion layer at a temperature higher than a temperature of the deposition step.
[25] In the manufacturing method for a through-via substrate according to any one of [21] to [24], the preparation step may include a through hole formation step of forming the through hole in the substrate.
[26] In a substrate used in the manufacturing method for a through-via substrate according to any one of [21] to [25],
   the substrate includes a first surface, a second surface positioned on an opposite side from the first surface, and a through hole penetrating from the first surface to the second surface,
   the through hole includes a side wall extending from the first surface to the second surface, and
   the side wall includes a first end connected to the first surface and a second end connected to the second surface.

According to the embodiment of the present disclosure, it is possible to suppress the peeling of the hole metal layer from the side wall of the through hole of the substrate.

### Brief Description of Drawings

[Fig. 1] Fig. 1 is a sectional view showing a through-via substrate according to an embodiment.
[Fig. 2] Fig. 2 is a sectional view showing a hole adhesion layer and a hole metal layer of the through-via substrate.
[Fig. 3] Fig. 3 is a sectional view for illustrating the thickness of the hole adhesion layer and the thickness of the hole metal layer.
[Fig. 4] Fig. 4 is a sectional view showing an example of a substrate in which through holes are formed.
[Fig. 5] Fig. 5 is a sectional view showing an example of an adhesion layer formation step.
[Fig. 6] Fig. 6 is a diagram showing an example of a deposition apparatus for forming an adhesion layer.
[Fig. 7] Fig. 7 is a sectional view showing an example of a metal layer formation step.
[Fig. 8] Fig. 8 is a sectional view showing an example of the metal layer formation step.
[Fig. 9] Fig. 9 is a sectional view showing an example of the metal layer formation step.
[Fig. 10] Fig. 10 is a sectional view showing an example of the metal layer formation step.
[Fig. 11] Fig. 11 is a sectional view showing a modification of the through-via substrate.
[Fig. 12] Fig. 12 is a sectional view showing a modification of the through-via substrate.
[Fig. 13] Fig. 13 is a sectional view showing a modification of the through-via substrate.
[Fig. 14] Fig. 14 is a sectional view showing a modification of the through-via substrate.
[Fig. 15] Fig. 15 is a sectional view showing a modification of the through-via substrate.
[Fig. 16] Fig. 16 is a sectional view showing a modification of the through-via substrate.
[Fig. 17A] Fig. 17A is a sectional view showing an example of a manufacturing method for a through-via substrate.
[Fig. 17B] Fig. 17B is a sectional view showing an example of the manufacturing method for a through-via substrate.
[Fig. 17C] Fig. 17C is a sectional view showing an example of the manufacturing method for a through-via substrate.
[Fig. 18A] Fig. 18A is a sectional view showing a modification of the through-via substrate.
[Fig. 18B] Fig. 18B is a sectional view showing a modification of the through-via substrate.
[Fig. 19] Fig. 19 is a sectional view showing a modification of the adhesion layer.
[Fig. 20] Fig. 20 is a sectional view showing a modification of the adhesion layer.
[Fig. 21] Fig. 21 is a sectional view showing a modification of the adhesion layer.
[Fig. 22] Fig. 22 is a sectional view showing a modification of the through-via substrate.
[Fig. 23] Fig. 23 is a diagram showing examples of a product to which the through-via substrate is mounted.
[Fig. 24] Fig. 24 is an image showing an adhesion layer in Example 1.
[Fig. 25] Fig. 25 is a graph showing the analysis results of the adhesion layer and substrate in Example 1.
[Fig. 26] Fig. 26 is a table showing the formation conditions of the adhesion layer and the results of a peeling test in Example 2.
[Fig. 27] Fig. 27 is a diagram showing a method for the peeling test in Example 2.
[Fig. 28A] Fig. 28A is an image showing an example of the adhesion layer in Example 2.
[Fig. 28B] Fig. 28B is a view showing the analysis results of an example of the adhesion layer in Example 2.
[Fig. 29A] Fig. 29A is an image showing an example of the adhesion layer in Example 2.
[Fig. 29B] Fig. 29B is a view showing the analysis results of an example of the adhesion layer in Example 2.

### Description of Embodiments

The structure of a through-via substrate and a manufacturing method for the through-via substrate will be described in detail with reference to the drawings. Embodiments described below are examples of the embodiment of the present disclosure, and the present disclosure should not be interpreted limitedly to these embodiments. In the specification, the terms "substrate", "base", "sheet", "film", and the like are not distinguished from each other by the name difference. For example, "substrate" is a concept including a member that can be called a sheet or a film. A "surface" indicates a surface that coincides with a planar direction of a plate-like member that is a target in a case where a target plate-like member is viewed from an overall and macro perspective. A normal direction used for a plate-like member indicates a normal direction to a surface of the member. Terms "parallel", "orthogonal", and the like, values of length and angle, and the like that determine shapes, geometrical conditions and the degrees of them, used in the specification, are not limited to strict meanings and are interpreted so as to include the range of degrees to which similar functions can be expected.

In the specification, when a plurality of upper limit candidates and a plurality of lower limit candidates are listed for a parameter, the numeric range of the parameter may be a combination of a selected one upper limit candidate and a selected one lower limit candidate. For example, the sentence "Parameter B, for example, may be larger than or equal to A1, may be larger than or equal to A2, or may be larger than or equal to A3. Parameter B, for example, may be smaller than or equal to A4, may be smaller than or equal to A5, or may be smaller than or equal to A6." will be discussed. In this case, the numeric range of parameter B may be larger than or equal to A1 and smaller than or equal to A4, may be larger than or equal to A1 and smaller than or equal to A5, may be larger than or equal to A1 and smaller than or equal to A6, may be larger than or equal to A2 and smaller than or equal to A4, may be larger than or equal to A2 and smaller than or equal to A5, may be larger than or equal to A2 and smaller than or equal to A6, may be larger than or equal to A3 and smaller than or equal to A4, may be larger than or equal to A3 and smaller than or equal to A5, or may be larger than or equal to A3 and smaller than or equal to A6.

In the attached drawings to be referenced in the present embodiments, the same or similar reference signs denote the same portions or portions having similar functions, and the repeated description can be omitted. The scale ratio of the drawings can be different from the actual ratio for the sake of convenience of illustration, and one or some of the components can be omitted from the drawings.

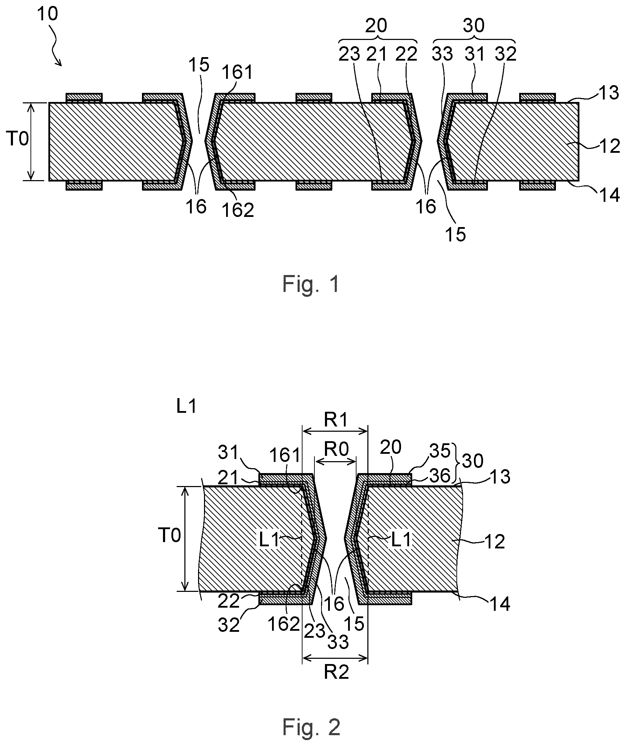

The embodiment of the present disclosure will be described. Fig. 1 is a sectional view showing an example of a through-via substrate 10. The through-via substrate 10 includes a substrate 12, an adhesion layer 20, and a metal layer 30.

### (Substrate)

The substrate 12 includes a first surface 13 and a second surface 14 positioned on the opposite side from the first surface 13. The substrate 12 has a through hole 15 that penetrates through the substrate 12 from the first surface 13 to the second surface 14. The substrate 12 may have a plurality of the through holes 15. Each of the through holes 15 has a side wall 16 that extends from the first surface 13 to the second surface 14. The side wall 16 expands in a direction intersecting the in-plane direction of the first surface 13 between the first surface 13 and the second surface 14. The side wall 16 includes a first end 161 connected to the first surface 13 and a second end 162 connected to the second surface 14.

The substrate 12 includes an inorganic material having electrical insulation properties. For example, the substrate 12 is a glass substrate, a quartz substrate, a sapphire substrate, a resin substrate, a silicon substrate, a silicon carbide substrate, an alumina (Al₂O₃) substrate, an aluminum nitride (AIN) substrate, a zirconium oxide (ZrO₂) substrate, or the like, or a laminate of some of these substrates. The substrate 12 may partially include a substrate made of a material having electrical conductivity, such as an aluminum substrate and a stainless steel substrate.

Examples of the glass used for the substrate 12 may include a non-alkali glass. Non-alkali glass is glass that does not include alkali components, such as sodium and potassium. Non-alkali glass includes, for example, boric acid instead of alkaline components. Non-alkali glass includes, for example, alkaline-earth metal oxide, such as calcium oxide and barium oxide.

The thickness T0 of the substrate 12 is, for example, greater than or equal to 100 µm, may be greater than or equal to 200 µm, or may be greater than or equal to 300 µm. The thickness T0 of the substrate 12 is, for example, less than or equal to 800 µm, may be less than or equal to 600 µm, or may be less than or equal to 400 µm.

Fig. 2 is an enlarged sectional view showing the through hole 15. The size of the through hole 15 in the in-plane direction of the first surface 13 is also referred to as the width of the through hole 15. In Fig. 2, reference sign R1 represents the width of the through hole 15 at the first surface 13, and reference sign R2 represents the width of the through hole 15 at the second surface 14.

The through hole 15 may include a portion of which the width varies according to a position in the thickness direction of the substrate 12. For example, the through hole 15 may include a portion of which the width reduces as the portion approaches from the first surface 13 toward a central position in the thickness direction of the substrate 12. The through hole 15 may include a portion of which the width reduces as the portion approaches from the second surface 14 toward the central position in the thickness direction of the substrate 12. In this case, the width of the through hole 15 is smallest at the center part in the thickness direction of the substrate 12. The "central position" is the position in the thickness direction of the substrate 12, which is equidistant from the first surface 13 and the second surface 14. The distance from the first surface 13 to the central position in the thickness direction of the substrate 12 is equal to the distance from the second surface 14 to the central position in the thickness direction of the substrate 12. The "center part" includes the central position in the thickness direction of the substrate 12, the range from the central position to a position 0.1 × T0 toward the first surface 13 and the range from the central position to a position 0.1 × T0 toward the second surface 14. Reference sign T0 represents the thickness of the substrate 12 as described above. The minimum value of the width of through hole 15 is represented by reference sign R0.

The width R1 of the through hole 15 at the first surface 13 is, for example, greater than or equal to 20 µm, may be greater than or equal to 30 µm, or may be greater than or equal to 40 µm. The width R1 of the through hole 15 at the first surface 13 is, for example, less than or equal to 150 µm, may be less than or equal to 100 µm, or may be less than or equal to 60 µm. The numeric range of the width R2 of the through hole 15 at the second surface 14 may be the same as the numeric range of the width R1. The numeric range of the width R0 may be the same as the numeric range of the width R1.

In Fig. 2, reference sign L1 represents a straight line connecting the first end 161 of the side wall 16 and the second end 162 of the side wall 16. The section of the side wall 16 positioned between the first end 161 and the second end 162 may be positioned inward of the straight line L1. "Inward" means a direction to approach the center point of the through hole 15 in a plan view.

The shape of the through hole 15 in a plan view is not limited. For example, the shape of the through hole 15 in a plan view may be circular or may be non-circular. When the shape of the through hole 15 in a plan view is circular, the width R1 is the diameter of the through hole 15 at the first surface 13, and the width R2 is the diameter of the through hole 15 at the second surface 14. When the shape of the through hole 15 in a plan view is not circular, the width R1 and the width R2 are defined in a direction in which the size of the through hole 15 in a plan view is maximum. When, for example, the shape of the through hole 15 in a plan view is elliptical, the width R1 and the width R2 are defined in a direction of the major axis of the elliptical shape.

T0/R0, which is the ratio of the thickness T0 of the substrate 12 to the width R0, is also referred to as the aspect ratio of the through hole 15. The aspect ratio of the through hole 15 is, for example, greater than or equal to 3.0, may be greater than or equal to 4.0, or may be greater than or equal to 5.0. The aspect ratio of the through hole 15 is, for example, less than or equal to 15.0, may be less than or equal to 12.0, or may be less than or equal to 10.0.

The side wall 16 of the through hole 15 may have a rough surface. The rough side wall 16 can contribute to the improvement of the adhesion of the adhesion layer 20 to the side wall 16. The arithmetic mean roughness Ra of the side wall 16 is, for example, greater than or equal to 0.05 nm, or may be greater than or equal to 0.10 nm. The arithmetic mean roughness Ra of the side wall 16 is, for example, less than or equal to 1.0 µm, or may be less than or equal to 0.5 µm. The arithmetic mean roughness Ra is defined based on JIS B 0601:2013.

### (Adhesion Layer)

The adhesion layer 20 is positioned between the substrate 12 and the metal layer 30. The adhesion layer 20 is a layer for enhancing the adhesion between the substrate 12 and the metal layer 30. The adhesion layer 20 includes at least a hole adhesion layer 23. The hole adhesion layer 23 expands on the side wall 16 from the first end 161 of the side wall 16 to the second end 162 of the side wall 16.

The adhesion layer 20 may include a first adhesion layer 21 positioned on the first surface 13. The first adhesion layer 21 may be connected to the hole adhesion layer 23 or does not need to be connected to the hole adhesion layer 23. For example, the first adhesion layer 21 may include a layer connected to the hole adhesion layer 23 and a layer not connected to the hole adhesion layer 23.

The adhesion layer 20 may include a second adhesion layer 22 positioned on the second surface 14. The second adhesion layer 22 may be connected to the hole adhesion layer 23 or does not need to be connected to the hole adhesion layer 23. For example, the second adhesion layer 22 may include a layer connected to the hole adhesion layer 23 and a layer not connected to the hole adhesion layer 23.

The adhesion layer 20 has a higher adhesion to the substrate 12 than the metal layer 30. In other words, the adhesion between the adhesion layer 20 and the substrate 12 is higher than the adhesion between the metal layer 30 and the substrate 12. For example, the peel strength of the adhesion layer 20 to the substrate 12 is higher than the peel strength of the metal layer 30 to the substrate 12. When the adhesion layer 20 is positioned between the substrate 12 and the metal layer 30, the peeling of the metal layer 30 from the substrate 12 can be suppressed.

The material of the adhesion layer 20 is selected according to the material of the substrate 12 and the material of the metal layer 30. The adhesion layer 20 may have electrical insulation properties. The adhesion layer 20 includes, for example, metal oxide. Examples of the metal oxide include titanium oxide, zinc oxide, aluminum oxide, tantalum oxide, magnesium oxide, hafnium oxide, and tin oxide. The chemical formula of titanium oxide is, for example, TiO₂. The chemical formula of zinc oxide is, for example, ZnO. The chemical formula of aluminum oxide is, for example, Al₂O₃. The chemical formula of tantalum oxide is, for example, Ta₂O₅. The chemical formula of magnesium oxide is, for example, MgO. The chemical formula of hafnium oxide is, for example, HfO₂. The chemical formula of tin oxide is, for example, SnO₂. The metal oxide of the adhesion layer 20 may be an oxide of the metal material (described later) that constitutes the metal layer 30.

The adhesion layer 20 may include metal oxide in a crystalline state. By enhancing the crystallinity of the metal oxide, the adhesion of the adhesion layer 20 to the substrate 12 can be enhanced. When the metal oxide of the adhesion layer 20 is titanium oxide, the crystal structure of titanium oxide may be of anatase type. Whether the metal oxide is in a crystalline state is determined based on the electron diffraction pattern of the adhesion layer 20. The electron diffraction pattern of metal oxides in a crystalline state includes a plurality of diffraction spots regularly arranged in at least one direction.

### (Metal Layer)

The metal layer 30 is a layer that includes a metal material. The metal layer 30 has electrical conductivity. The metal layer 30 transmits electric power, electrical signals, and the like, in the through-via substrate 10. The metal layer 30 may be electrically connected to terminals, electrodes, connectors, and the like of wiring substrates, semiconductor elements, and the like connected to the through-via substrate 10.

The metal layer 30 includes at least the hole metal layer 33. The hole metal layer 33 is positioned in the through hole 15 of the substrate 12. The hole metal layer 33 expands in the thickness direction of the substrate 12 so as to extend from the first surface 13 to the second surface 14. The hole adhesion layer 23 of the adhesion layer 20 is positioned between the side wall 16 of the through hole 15 and the hole metal layer 33.

The metal layer 30 may include a first metal layer 31 positioned on the first surface 13. The first metal layer 31 may be connected to the hole metal layer 33 or does not need to be connected to the hole metal layer 33. For example, the first metal layer 31 may include a layer connected to the hole metal layer 33 and a layer not connected to the hole metal layer 33. The first adhesion layer 21 of the adhesion layer 20 is positioned between the first surface 13 of the substrate 12 and the first metal layer 31.

The metal layer 30 may include a second metal layer 32 positioned on the second surface 14. The second metal layer 32 may be connected to the hole metal layer 33 or does not need to be connected to the hole metal layer 33. For example, the second metal layer 32 may include a layer connected to the hole metal layer 33 and a layer not connected to the hole metal layer 33. The second adhesion layer 22 of the adhesion layer 20 is positioned between the second surface 14 of the substrate 12 and the second metal layer 32.

Examples of the metal material of the metal layer 30 include metals such as copper, aluminum, nickel, gold, and tungsten, and alloys of these metals.

The metal layer 30 may be composed of a single layer or may include a plurality of layers as shown in Fig. 2. For example, the metal layer 30 may include a body layer 35 and an intermediate layer 36. Both the body layer 35 and the intermediate layer 36 include the above-described metal material. The intermediate layer 36 is positioned between the body layer 35 and the adhesion layer 20. The intermediate layer 36 may be in contact with both the body layer 35 and the adhesion layer 20.

The intermediate layer 36 may be thinner than the body layer 35. The metal material of the intermediate layer 36 may be the same as the metal material of the body layer 35 or may be different from the metal material of the body layer 35. When the metal material of the intermediate layer 36 is the same as the metal material of the body layer 35, the boundary between the body layer 35 and the intermediate layer 36 can be visually indistinguishable.

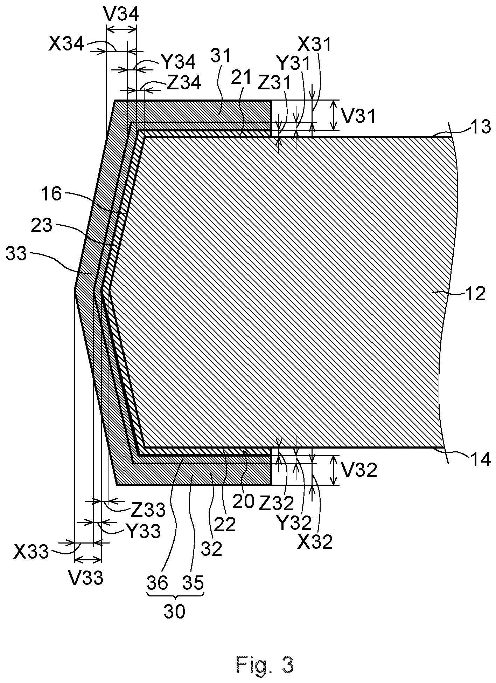

The thickness of the adhesion layer 20 and the thickness of the metal layer 30 will be described with reference to Fig. 3.

Reference sign Z31 represents the thickness of the first adhesion layer 21. Reference sign Z32 represents the thickness of the second adhesion layer 22. Reference sign Z33 represents the thickness of the hole adhesion layer 23 at the central position in the thickness direction of the substrate 12. The thickness of the hole adhesion layer 23 at the central position is also referred to as central thickness. Reference sign Z34 represents the thickness of the hole adhesion layer 23 at the position of the first surface 13 of the substrate 12. The thickness of the hole adhesion layer 23 at the position of the first surface 13 is also referred to as edge thickness.

Z34/Z33, which is the ratio of the edge thickness Z34 to the central thickness Z33 of the hole adhesion layer 23, is, for example, less than or equal to 1.10, may be less than or equal to 1.08, or may be less than or equal to 1.05. Z34/Z33 is, for example, greater than or equal to 0.95, may be greater than or equal to 0.98, or may be greater than or equal to 1.00. Generally, it becomes more difficult to form the hole adhesion layer 23 as the position approaches the central position in the thickness direction of the substrate 12. In particular, when the aspect ratio of the through hole 15 is high, or when the thickness of the adhesion layer 20 is small, it becomes difficult to form the hole adhesion layer 23. For example, a situation where the hole adhesion layer 23 is not formed on a part of the side wall 16 is likely to occur. In the part of the side wall 16 where the hole adhesion layer 23 is not formed, the peeling of the hole metal layer 33 from the side wall 16 is likely to occur.

The fact that the ratio of the edge thickness Z34 to the central thickness Z33 is less than or equal to 1.10 means that the hole adhesion layer 23 is uniformly formed along the entire area of the side wall 16. As a result, the adhesion of the metal layer 30 to the substrate 12 is enhanced across the entire area of the side wall 16. Therefore, even when the aspect ratio of the through hole 15 is high or the thickness of the adhesion layer 20 is small, the peeling of the hole metal layer 33 from the side wall 16 can be suppressed.

The numeric range of Z31/Z33, which is the ratio of the thickness Z31 of the first adhesion layer 21 to the central thickness Z33 of the hole adhesion layer 23, may be the same as the numeric range of Z34/Z33. The numeric range of Z32/Z33, which is the ratio of the thickness Z32 of the second adhesion layer 22 to the central thickness Z33 of the hole adhesion layer 23, may be the same as the numeric range of Z34/Z33.

The central thickness Z33 of the hole adhesion layer 23 is, for example, greater than or equal to 5.0 nm, may be greater than or equal to 8.0 nm, or may be greater than or equal to 10.0 nm. The central thickness Z33 of the hole adhesion layer 23 is, for example, less than or equal to 100 nm, may be less than or equal to 60 nm, or may be less than or equal to 40 nm.

Reference sign V31 represents the thickness of the first metal layer 31. Reference sign V32 represents the thickness of the second metal layer 32. Reference sign V33 represents the thickness of the hole metal layer 33 at the central position in the thickness direction of the substrate 12. The thickness of the hole metal layer 33 at the central position is also referred to as central thickness. Reference sign V34 represents the thickness of the hole metal layer 33 at the position of the first surface 13 of the substrate 12.

**V31/V33,** which is the ratio of the thickness V31 of the first metal layer 31 to the central thickness V33 of the hole metal layer 33, is, for example, less than or equal to 1.50, may be less than or equal to 1.40, or may be less than or equal to 1.30. V31/V33 is, for example, greater than or equal to 0.95, may be greater than or equal to 1.00, or may be greater than or equal to 1.05.

The numeric range of V32/V33, which is the ratio of the thickness V32 of the second metal layer 32 to the central thickness V33 of the hole metal layer 33, may be the same as the numeric range of V31/V33. The numeric range of V34/V33, which is the ratio of the thickness V34 of the hole metal layer 33 at the first surface 13 to the central thickness V33 of the hole metal layer 33, may be the same as the numeric range of V31/V33.

The central thickness V33 of the hole metal layer 33 is, for example, greater than or equal to 0.5 µm, may be greater than or equal to 1.0 µm, or may be greater than or equal to 3.0 µm. The central thickness V33 of the hole metal layer 33 is, for example, less than or equal to 30 µm, may be less than or equal to 20 µm, or may be less than or equal to 10 µm.

Reference sign X31 represents the thickness of the body layer 35 of the first metal layer 31. Reference sign X32 represents the thickness of the body layer 35 of the second metal layer 32. Reference sign X33 represents the thickness of the body layer 35 of the hole metal layer 33 at the central position in the thickness direction of the substrate 12. Reference sign X34 represents the thickness of the body layer 35 of the hole metal layer 33 at the position of the first surface 13 of the substrate 12.

The numeric range of X31/X33, which is the ratio of the thickness X31 of the body layer 35 of the first metal layer 31 to the thickness X33 of the body layer 35 of the hole metal layer 33 at the central position, may be the same as the numeric range of V31/V33. The numeric range of X32/X33, which is the ratio of the thickness X32 of the body layer 35 of the second metal layer 32 to the thickness X33 of the body layer 35 of the hole metal layer 33 at the central position, may be the same as the numeric range of V31/V33. The numeric range of X34/X33, which is the ratio of the thickness X34 of the body layer 35 of the hole metal layer 33 at the first surface 13 to the thickness X33 of the body layer 35 of the hole metal layer 33 at the central position, may be the same as the numeric range of V31/V33.

The thickness X33 of the body layer 35 of the hole metal layer 33 at the central position is, for example, greater than or equal to 0.5 µm, may be greater than or equal to 1.0 µm, or may be greater than or equal to 3.0 µm. The thickness X33 of the body layer 35 of the hole metal layer 33 at the central position is, for example, less than or equal to 30 µm, may be less than or equal to 20 µm, or may be less than or equal to 10 µm.

Reference sign Y31 represents the thickness of the intermediate layer 36 of the first metal layer 31. Reference sign Y32 represents the thickness of the intermediate layer 36 of the second metal layer 32. Reference sign Y33 represents the thickness of the intermediate layer 36 of the hole metal layer 33 at the central position in the thickness direction of the substrate 12. Reference sign Y34 represents the thickness of the intermediate layer 36 of the hole metal layer 33 at the position of the first surface 13 of the substrate 12.

Y31/Y33, which is the ratio of the thickness Y31 of the intermediate layer 36 of the first metal layer 31 to the thickness Y33 of the intermediate layer 36 of the hole metal layer 33 at the central position, is, for example, greater than or equal to 2.0, may be greater than or equal to 3.0, or may be greater than or equal to 4.0. Y31/Y33 is, for example, less than or equal to 15.0, may be less than or equal to 10.0, or may be less than or equal to 8.0. As will be described later, the intermediate layer 36 is formed by, for example, electroless plating. For this reason, the thickness Y33 of the intermediate layer 36 of the hole metal layer 33 at the central position is likely to be less than the thickness Y31 of the intermediate layer 36 of the first metal layer 31. The numeric range of Y32/Y33, which is the ratio of the thickness Y32 of the intermediate layer 36 of the second metal layer 32 to the thickness Y33 of the intermediate layer 36 of the hole metal layer 33 at the central position, may be the same as the numeric range of Y31/Y33. The numeric range of Y34/Y33, which is the ratio of the thickness Y34 of the intermediate layer 36 of the hole metal layer 33 at the first surface 13 to the thickness Y33 of the intermediate layer 36 of the hole metal layer 33 at the central position, may be the same as the numeric range of Y31/Y33.

The thickness Y33 of the intermediate layer 36 of the hole metal layer 33 at the central position is, for example, greater than or equal to 5.0 nm, may be greater than or equal to 8.0 nm, or may be greater than or equal to 10.0 nm. The thickness Y33 of the intermediate layer 36 of the hole metal layer 33 at the central position is, for example, less than or equal to 200 nm, may be less than or equal to 100 nm, or may be less than or equal to 50 nm.

The thickness of the adhesion layer 20 and the thickness of the metal layer 30 are calculated based on the image of the cross section of the through-via substrate 10, obtained with an electron microscope. The thickness of the first adhesion layer 21 and the thickness of the first metal layer 31 are measured at a position 10 mm away from the first end 161 in the in-plane direction of the first surface 13. The thickness of the second adhesion layer 22 and the thickness of the second metal layer 32 are measured at a position 10 mm away from the second end 162 in the in-plane direction of the second surface 14.

### (Manufacturing Method for Through-Via Substrate)

Next, an example of a manufacturing method for the through-via substrate 10 will be described.

### (Preparation Step)

A preparation step of preparing the substrate 12 in which the through holes 15 are formed is performed. The preparation step includes a through hole formation step (described later). The through hole formation step may be performed by those who manufacture the final through-via substrate 10. Alternatively, those who manufacture the final through-via substrate 10 may procure, from a third party, the substrate 12 in which the through holes 15 are formed.

### (Through Hole Formation Step)

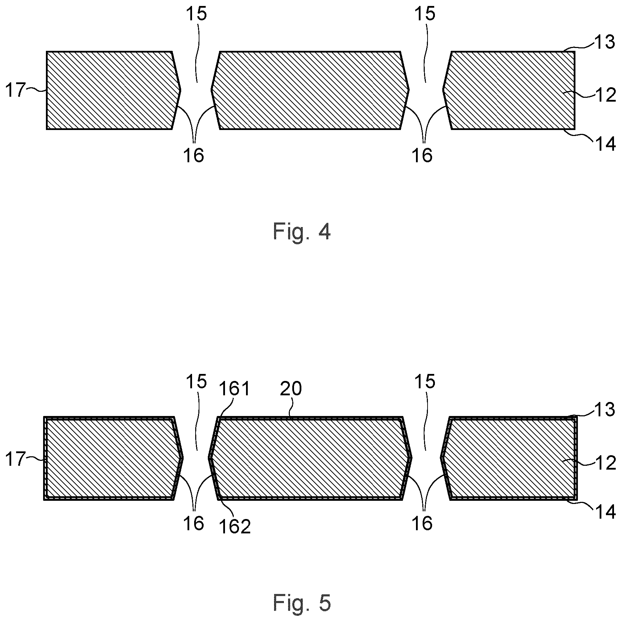

In the through hole formation step, initially, the substrate 12 in which no through hole 15 is formed is prepared. Subsequently, a resist layer is provided on at least one of the first surface 13 and the second surface 14. Then, openings are provided at the positions corresponding to the through holes 15 in the resist layer. Subsequently, the substrate 12 is worked at the openings of the resist layer. Thus, as shown in Fig. 4, the through holes 15 can be formed in the substrate 12. Each of the through holes 15 has the side wall 16 that extends from the first surface 13 to the second surface 14. Dry etching, wet etching, and the like, can be used as a method of working the substrate 12. Dry etching is reactive ion etching, deep reactive ion etching, or the like.

The through holes 15 may be formed in the substrate 12 by applying laser to the substrate 12. In this case, a resist layer does not need to be provided. Excimer laser, Nd:YAG laser, femtosecond laser, or the like, may be used as laser. When Nd:YAG laser is adopted, a fundamental with a wavelength of 1064 nm, a second harmonic with a wavelength of 532 nm, a third harmonic with a wavelength of 355 nm, and the like, can be used.

Laser irradiation and wet etching may be combined as needed. Specifically, initially, an altered layer is formed by laser irradiation in the areas where the through holes 15 are to be formed in the substrate 12. Subsequently, the substrate 12 is immersed in hydrogen fluoride or the like to etch the altered layer. Thus, the through holes 15 can be formed in the substrate 12.

Additionally, the through holes 15 may be formed in the substrate 12 by blasting where abrasive material is sprayed onto the substrate 12.

### (Adhesion Layer Formation Step)

Next, as shown in Fig. 5, an adhesion layer formation step of forming the adhesion layer 20 on the surface of the substrate 12 is performed. The adhesion layer 20 is formed on at least the side walls 16 of the through holes 15. The adhesion layer 20 may be formed on the first surface 13. The adhesion layer 20 may be formed on the second surface 14. The adhesion layer 20 may be formed on a side surface 17 of the substrate 12. The side surface 17 is a surface that defines the outer edge of substrate 12 in a plan view.

The adhesion layer formation step includes a deposition step of forming the adhesion layer 20 on the surface of the substrate 12 by chemical vapor deposition (CVD). In the deposition step, the adhesion layer 20 may be formed on the surface of the substrate 12 by atomic layer deposition (ALD). Atomic layer deposition is a deposition method that uses the chemical reaction of source gas on the surface of the substrate 12. Atomic layer deposition is a kind of chemical vapor deposition, so-called CVD. By using atomic layer deposition, the adhesion layer 20 can be stably formed on the surface of the substrate 12. For example, the adhesion layer 20 can be formed uniformly over the entire areas of the side walls 16.

In the deposition step, the adhesion layer 20 may be formed on the surface of the substrate 12 by chemical vapor deposition other than atomic layer deposition.

An example of the deposition step in the case where the adhesion layer 20 is formed by atomic layer deposition will be described. The deposition step includes multiple deposition processes. A one-time deposition process includes a first supply process, a first purge process, a second supply process, and a second purge process.

In the first supply process, source gas including a first reactant is supplied to the substrate 12. The first reactant is also referred to as a precursor. The first reactant is, for example, a chemical compound including a metal that constitutes the metal oxide of the adhesion layer 20. The first reactant may be a chemical compound of organic matter with a metal that constitutes the metal oxide of the adhesion layer 20.

The first reactant reacts with the surface of the substrate 12 in a self-regulating manner. For example, the reaction of the first reactant occurs only at a plurality of reactive sites on the surface of substrate 12. A film made of the first reactant is formed on the surface of the substrate 12 as a result of the reaction of the first reactant. When all the reactive sites on the surface of the substrate 12 are filled by the first reactant, the growth of the film stops.

Subsequently, the first purge process is performed. In the first purge process, the first reactant remaining around the substrate 12 is removed. For example, the source gas including the first reactant is emitted to the outside of the chamber of the deposition apparatus for performing the deposition step.

Subsequently, the second supply process is performed. In the second supply process, the source gas including a second reactant is supplied to the substrate 12. A second reactant is oxygen molecules, water molecules, or the like. A second reactant may include a reactive oxygen radical.

In the second supply process, the surface ligands of the first reactant that constitutes the film are replaced by oxygen. In other words, an oxidation reaction occurs. As a result, a metal oxide film is formed on the surface of the substrate 12. When all the surface ligands are replaced by oxygen, the oxidation reaction stops.

Subsequently, the second purge process is performed. In the second purge process, the second reactant remaining around the substrate 12 is removed. For example, the source gas including the second reactant is emitted to the outside of the chamber of the deposition apparatus for performing the deposition step.

The thickness of the metal oxide film formed by one-time deposition process is, for example, less than or equal to 0.20 nm, may be less than or equal to 0.15 nm, or may be less than or equal to 0.10 nm. By controlling the number of deposition processes, the thickness of the adhesion layer 20 can be controlled.

**As** described above, self-regulation of the reaction is implemented in atomic layer deposition, so a uniform and dense adhesion layer 20 with suppressed defects, such as pinholes, is obtained. A reaction occurs between the plurality of reactive sites on the surface of the substrate 12 and the adhesion layer 20, so the adhesion of the adhesion layer 20 to the substrate 12 is enhanced.

Atomic layer deposition also has such an advantage that the adhesion layer 20 can be formed at a low temperature compared to other chemical vapor deposition methods, such as plasma CVD. Atomic layer deposition also has such an advantage that the adhesion layer 20 can be formed on the side walls 16 of the through holes 15 with a high aspect ratio compared to other chemical vapor deposition methods, such as plasma CVD. For example, atomic layer deposition can form the adhesion layer 20 on the side walls 16 of the through holes 15 with an aspect ratio of 100 or greater.

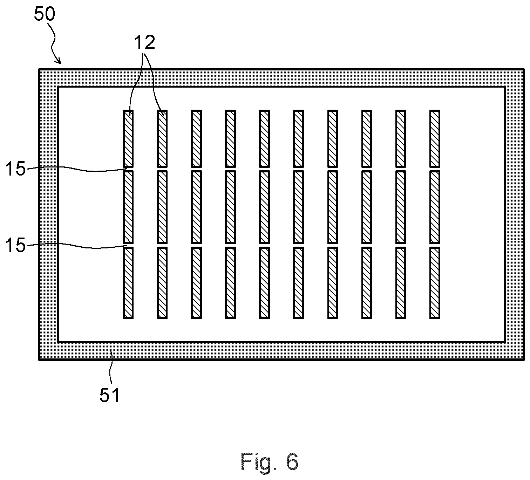

Fig. 6 is a diagram showing an example of a deposition apparatus 50 for performing the deposition step. The deposition apparatus 50 includes a chamber 51 in which the substrate 12 is accommodated. The deposition process is repeatedly performed in the chamber 51.

As shown in Fig. 6, the chamber 51 may accommodate a plurality of the substrates 12. In this case, the deposition process is collectively performed for the plurality of substrates 12. Thus, it is possible to enhance the productivity of the through-via substrate 10.

The deposition step may be performed in a high-temperature environment. The temperature of the deposition step may be adjusted according to the reaction temperature of the first reactant and the reaction temperature of the second reactant. The temperature of the deposition step is, for example, higher than or equal to 100°C, may be higher than or equal to 120°C, or may be higher than or equal to 150°C. The temperature of the deposition step is, for example, lower than or equal to 250°C, may be lower than or equal to 220°C, or may be lower than or equal to 200°C. The temperature of the deposition step may be an atmosphere temperature inside the chamber 51.

The adhesion layer formation step may include an annealing step that is performed after the deposition step. In the annealing step, the adhesion layer 20 is heated at a temperature higher than the temperature of the deposition step. The temperature of the annealing step may be adjusted such that the crystallization of the metal oxide included in the adhesion layer 20 advances. The temperature of the annealing step is, for example, higher than or equal to 150°C, may be higher than or equal to 200°C, or may be higher than or equal to 250°C. The temperature of the annealing step is, for example, lower than or equal to 600°C, may be lower than or equal to 550°C, or may be lower than or equal to 500°C. When the metal oxide included in the adhesion layer 20 is titanium oxide, the temperature of the annealing step may be lower than or equal to 400°C.

The difference between the temperature of the deposition step and the temperature of the annealing step is, for example, greater than or equal to 50°C, may be greater than or equal to 100°C, or may be greater than or equal to 150°C. The difference between the temperature of the deposition step and the temperature of the annealing step is, for example, less than or equal to 500°C, may be less than or equal to 400°C, or may be less than or equal to 300°C.

The annealing step may be performed in an atmosphere of inert gas. The concentration of inert gas in the atmosphere is, for example, higher than or equal to 90%, may be higher than or equal to 95%, may be higher than or equal to 98%, or may be higher than or equal to 99%. Inert gas may be nitrogen gas or may be noble gas, such as argon gas and helium gas.

The annealing step may promote the diffusion of metal atoms constituting the metal oxide of the adhesion layer 20 into the substrate 12. The substrate 12 may include a surface layer that includes a metal that is the same as a metal constituting the metal oxide of the adhesion layer 20. The surface layer is a thin layer that constitutes the surface of the substrate 12, such as the side wall 16. The adhesion of the adhesion layer 20 to the substrate 12 is enhanced by the diffusion of metal atoms into the substrate 12.

Whether the surface layer of the substrate 12 includes a metal that constitutes the metal oxide of the adhesion layer 20 is determined based on the results obtained by analyzing the composition of a sample, including the substrate 12 and the adhesion layer 20, by X-ray photoelectron spectroscopy. Specifically, when M22/M21 at a boundary position P1 (described later) is greater than or equal to a determination threshold, it is determined that the surface layer of the substrate 12 includes metal atoms that constitute the metal oxide of the adhesion layer 20. In other words, it is determined that the surface layer of the substrate 12 includes the same metal atoms as the metal atoms constituting the metal oxide of the adhesion layer 20. The boundary position P1 is the position where the atomic concentration of the main component of the substrate 12 is 50% of the maximum atomic concentration. When the substrate 12 is made of glass, the main component is silicon. M21 is the maximum atomic concentration of the metal that constitutes the metal oxide of the adhesion layer 20. M22 is the atomic concentration of the metal that constitutes the metal oxide of the adhesion layer 20 at the boundary position P1. The determination threshold is, for example, 0.20, may be 0.30, or may be 0.50.

The thickness T10 of the surface layer is, for example, greater than or equal to 2.0 nm, may be greater than or equal to 3.0 nm, or may be greater than or equal to 4.0 nm. As the thickness T10 of the surface layer increases, the higher adhesion of the adhesion layer 20 to the substrate 12 is expected. The thickness T10 of the surface layer is, for example, less than or equal to 20.0 nm, may be less than or equal to 15.0 nm, or may be less than or equal to 10.0 nm. The thickness T10 of the surface layer is a distance in the thickness direction of the substrate 12 from the boundary position P1 (described later) to an inner boundary position P2. The inner boundary position P2 is the position where the concentration of metal constituting the metal oxide of the adhesion layer 20 is 0.10 times the maximum atomic concentration M21.

The concentration of metal that constitutes the metal oxide of the adhesion layer 20 is calculated by X-ray photoelectron spectroscopy. In X-ray photoelectron spectroscopy, photoelectrons emitted from a target object as a result of X-ray irradiation is detected while the target object is being etched in the thickness direction by ion sputter etching. The thickness T10 of the surface layer is calculated by converting the time difference of ion sputter etching between the boundary position P1 and the inner boundary position P2 into a distance based on an etching rate.

### (Metal Layer Formation Step)

Next, the metal layer formation step of forming the metal layer 30 on the adhesion layer 20 is performed. The metal layer formation step may include an intermediate layer formation step, a resist layer formation step, a body layer formation step, a resist layer removal step, and an intermediate layer removal step.

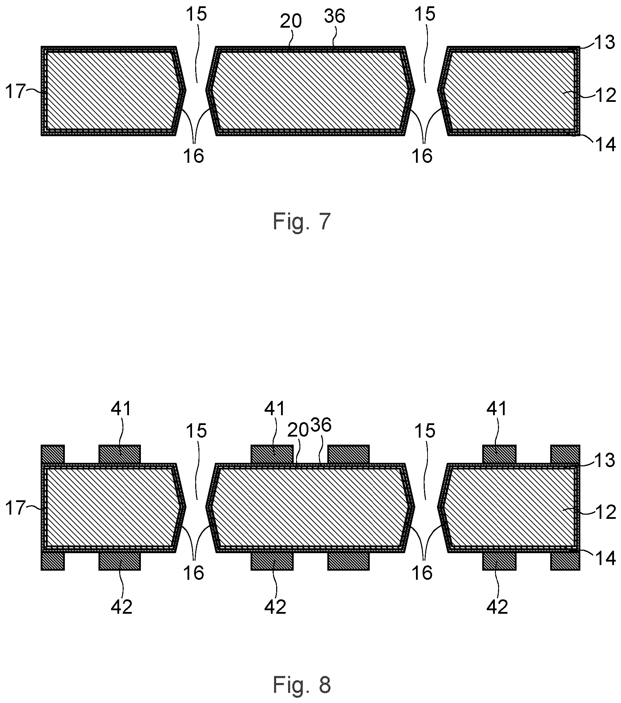

Fig. 7 is a sectional view showing an example of the intermediate layer formation step. In the intermediate layer formation step, the intermediate layer 36 is formed on the adhesion layer 20.

In the intermediate layer formation step, the intermediate layer 36 may be formed on the adhesion layer 20 by electroless plating. For example, the substrate 12 on which the adhesion layer 20 is formed may be immersed in an electroless plating solution.

The intermediate layer 36 may be formed by methods other than electroless plating. For example, the intermediate layer 36 may be formed by physical vapor deposition (PVD). Examples of physical vapor deposition include evaporation and sputtering.

The intermediate layer formation step may include an intermediate layer annealing step of heating the intermediate layer 36. The temperature of the intermediate layer annealing step is, for example, higher than or equal to 150°C, may be higher than or equal to 200°C, or may be higher than or equal to 230°C. The temperature of the intermediate layer annealing step is, for example, lower than or equal to 350°C, may be lower than or equal to 300°C, or may be lower than or equal to 270°C.

The intermediate layer annealing step may be performed in an atmosphere of inert gas. The concentration of inert gas in the atmosphere is, for example, higher than or equal to 90%, may be higher than or equal to 95%, may be higher than or equal to 98%, or may be higher than or equal to 99%. Inert gas may be nitrogen gas or may be noble gas, such as argon gas and helium gas.

Fig. 8 is a sectional view showing an example of the resist layer formation step. In the resist layer formation step, a first resist layer 41 is partially formed on the intermediate layer 36 positioned on the first surface 13, and a second resist layer 42 is partially formed on the intermediate layer 36 positioned on the second surface 14. The first resist layer 41 is provided so as to cover the area where the first metal layer 31 is not to be formed. The second resist layer 42 is provided so as to cover the area where the second metal layer 32 is not to be formed. A photosensitive material, such as a dry film resist including acrylic resin, may be used as the material of the resist layers 41, 42.

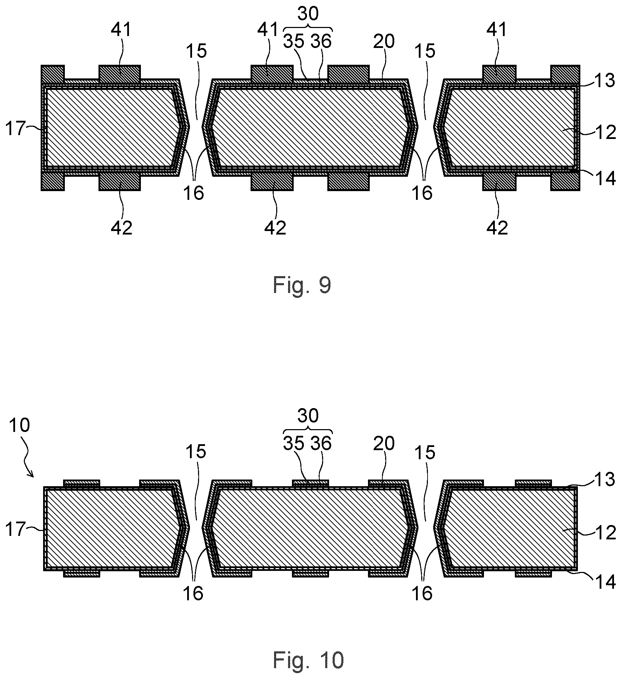

Fig. 9 is a sectional view showing an example of the body layer formation step. In the intermediate layer formation step, the body layer 35 is formed on the intermediate layer 36 in areas where the resist layers 41, 42 are not formed. The body layer formation step may be performed such that the body layer 35 is not to be formed on the intermediate layer 36 positioned on the side surface 17.

In the body layer formation step, the body layer 35 may be formed on the intermediate layer 36 by electrolytic plating. For example, the substrate 12, on which the intermediate layer 36 and the resist layers 41, 42 are formed, may be immersed in an electrolytic plating solution. By passing current through the intermediate layer 36, the body layer 35 is precipitated on the intermediate layer 36.

The body layer 35 may be formed by methods other than electrolytic plating. For example, the body layer 35 may be formed by physical vapor deposition (PVD). Examples of physical vapor deposition include evaporation and sputtering.

When physical vapor deposition is used, the metal layer 30 may be composed of a single layer. For example, the metal layer 30 may include only one layer formed by physical vapor deposition.

The body layer formation step may include a body layer annealing step of heating the body layer 35. The temperature of the body layer annealing step is, for example, higher than or equal to 150°C, may be higher than or equal to 200°C, or may be higher than or equal to 250°C. The temperature of the body layer annealing step is, for example, lower than or equal to 600°C, may be lower than or equal to 550°C, or may be lower than or equal to 500°C. The temperature of the body layer annealing step may be higher than the temperature of the intermediate layer annealing step.

The body layer annealing step may be performed in an atmosphere of inert gas. The concentration of inert gas in the atmosphere is, for example, higher than or equal to 90%, may be higher than or equal to 95%, may be higher than or equal to 98%, or may be higher than or equal to 99%. Inert gas may be nitrogen gas or may be noble gas, such as argon gas and helium gas.

Fig. 10 is a sectional view showing an example of the resist layer removal step. In the resist layer removal step, the resist layers 41, 42 are removed. Subsequently, the intermediate layer removal step is performed. In the intermediate layer removal step, as shown in Fig. 10, the intermediate layer 36 that overlaps the resist layers 41, 42 in a plan view is removed. Thus, the through-via substrate 10 is obtained.

Subsequently, an adhesion layer removal step may be performed. In the adhesion layer removal step, the intermediate layer 36 that overlaps the resist layers 41, 42 in a plan view may be removed. Thus, the through-via substrate 10 shown in Fig. 1 is obtained.

In the present embodiment, the adhesion layer 20 can enhance the adhesion between the substrate 12 and the metal layer 30. Therefore, the peeling of the hole metal layer 33 from the side wall 16 of the through hole 15 is suppressed.

The above-described embodiment can be variously modified. Hereinafter, modifications will be described with reference to the drawings as needed. In the following description and the drawings used in the following description, like reference signs to the reference signs used for corresponding portions in the above-described embodiment are used for portions that can be similarly configured to those of the above-described embodiment. The description thereof will not be repeated. When the operation and advantageous effects obtained in the above-described embodiment are also apparently obtained in the modifications, the description thereof may be omitted.

### (First Modification)

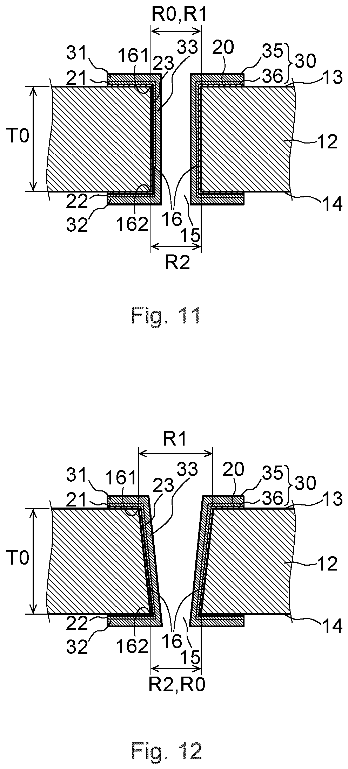

Fig. 11 is a sectional view showing a through-via substrate 10 in the first modification. The width of the through hole 15 of the substrate 12 may be constant from the first surface 13 to the second surface 14. In this case, the width R1 of the through hole 15 at the first surface 13 and the width R2 of the through hole 15 at the second surface 14 are the same. The minimum value R0 of the width of through hole 15 is also the same as the width R1 and the width R2.

### (Second Modification)

Fig. 12 is a sectional view showing a through-via substrate 10 in the second modification. The width of the through hole 15 may decrease as the through hole 15 extends from the first surface 13 to the second surface 14. In this case, the width R1 of the through hole 15 at the first surface 13 is greater than the width R2 of the through hole 15 at the second surface 14. The minimum value R0 of the width of the through hole 15 may be the width R2 of the through hole 15 at the second surface 14.

### (Third Modification)

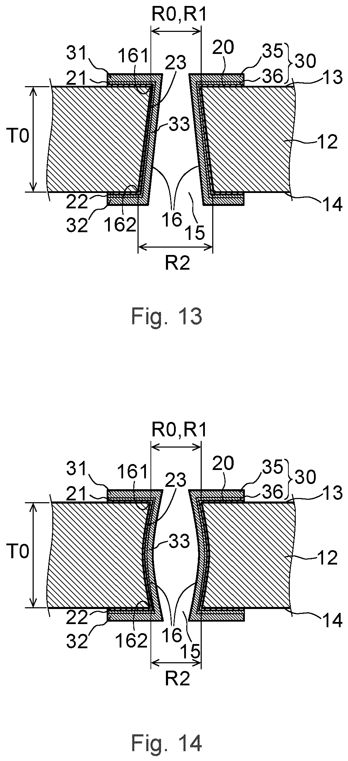

Fig. 13 is a sectional view showing a through-via substrate 10 in the third modification. The width of the through hole 15 may increase as the through hole 15 extends from the first surface 13 to the second surface 14. In this case, the width R1 of the through hole 15 at the first surface 13 is less than the width R2 of the through hole 15 at the second surface 14. The minimum value R0 of the width of the through hole 15 may be the width R1 of the through hole 15 at the first surface 13.

### (Fourth Modification)

Fig. 14 is a sectional view showing a through-via substrate 10 in the fourth modification. The through hole 15 may include a portion of which the width increases as the portion approaches from the first surface 13 toward the central position in the thickness direction of the substrate 12. The through hole 15 may include a portion of which the width increases as the portion approaches from the second surface 14 toward the central position in the thickness direction of the substrate 12. In this case, the width of the through hole 15 is maximum at a center part in the thickness direction of the substrate 12. The minimum value R0 of the width of the through hole 15 may be the width R1 of the through hole 15 at the first surface 13. The minimum value R0 of the width of the through hole 15 may be the width R2 of the through hole 15 at the second surface 14.

### (Fifth Modification)

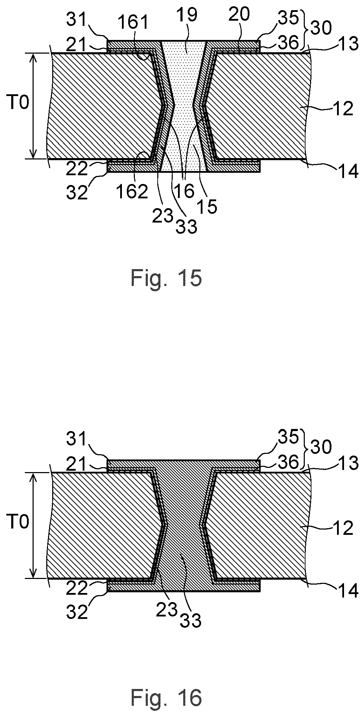

Fig. 15 is a sectional view showing a through-via substrate 10 in the fifth modification. In the above-described embodiment and the first to fourth modifications, the examples where there is a space in the through hole 15 have been described. Specifically, the examples where there is a space between the hole metal layers 33 on the opposing side walls 16 in the in-plane direction of the first surface 13 have been described. In this case, as shown in Fig. 15, the through-via substrate 10 may include an insulating layer 19 positioned between the opposing hole metal layers 33 in the in-plane direction of the first surface 13.

The insulating layer 19 includes a material having electrical insulation properties. The insulating layer 19 may include, for example, polyimide.

### (Sixth Modification)

Fig. 16 is a sectional view showing a through-via substrate 10 in the sixth modification. As shown in Fig. 16, the hole metal layer 33 may continuously expand in the in-plane direction between the opposing side walls 16 in the in-plane direction of the first surface 13.

An example of a step of forming the hole metal layer 33 shown in Fig. 16 will be described. In this modification as well, similarly to the above-described embodiment shown in Fig. 9, the hole metal layer 33 is formed along the side wall 16 of the through hole 15. For example, the body layer 35 of the hole metal layer 33 is formed by electrolytic plating.

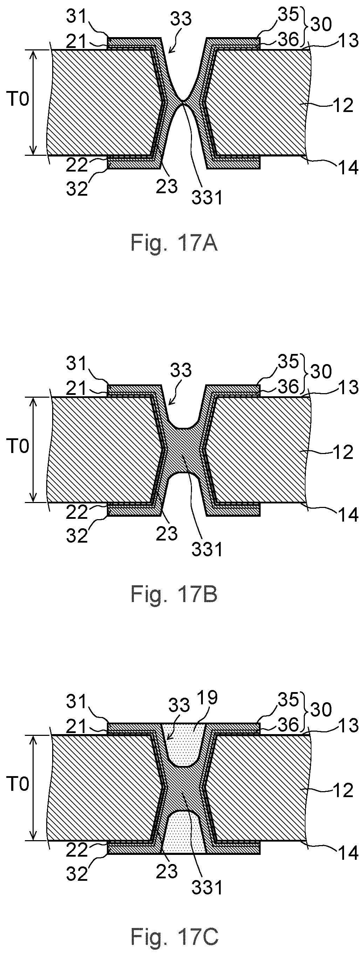

When electrolytic plating is further continued from the state shown in Fig. 9, the through hole 15 is closed by the hole metal layer 33 in part of the through hole 15 as shown in Fig. 17A. For example, the hole metal layer 33 that continuously expands in the in-plane direction of the first surface 13 is formed at the center part in the thickness direction of the substrate 12. The part of the hole metal layer 33 that closes the through hole 15 is also referred to as a closed portion 331.

When electrolytic plating is further continued from the state shown in Fig. 9, the closed portion 331 grows in the thickness direction of the substrate 12 as shown in Fig. 17B. By continuing electrolytic plating until the end surface of the closed portion 331 in the thickness direction of the substrate 12 reaches the first surface 13 and the second surface 14, the hole metal layer 33 shown in Fig. 16 is obtained.

Electrolytic plating for forming the hole metal layer 33 may end in a state where the end surfaces of the closed portion 331 in the thickness direction of the substrate 12 have not reached the first surface 13 and the second surface 14, as shown in Fig. 17B. In other words, the through-via substrate 10 may include the hole metal layer 33 including the closed portion 331 of which end surfaces in the thickness direction of the substrate 12 have not reached the first surface 13 and the second surface 14. The through-via substrate 10 with the hole metal layer 33 shown in Fig. 17B may be sold or used.

As shown in Fig. 17C, the through-via substrate 10 may include an insulating layer 19 positioned between the opposing hole metal layers 33 in the in-plane direction of the first surface 13. The insulating layer 19 may be in contact with the end surfaces of the closed portion 331 in the thickness direction of the substrate 12.

### (Seventh Modification)

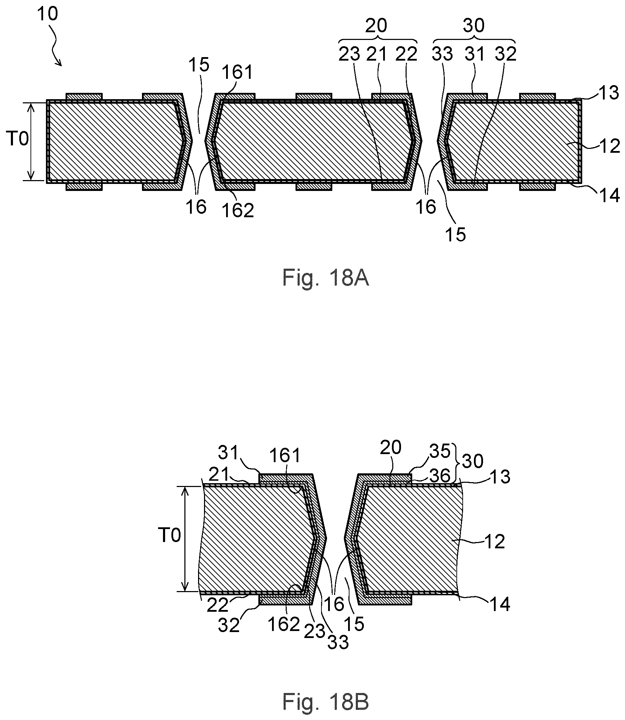

Figs. 18A and 18B are sectional views showing a through-via substrate 10 in the seventh modification. The adhesion layer 20 may include a portion that does not overlap the metal layer 30, in addition to the portion positioned between the substrate 12 and the metal layer 30. For example, the first adhesion layer 21 may include a portion that does not overlap the first metal layer 31 in a plan view, in addition to the portion positioned between the substrate 12 and the first metal layer 31. For example, the first adhesion layer 21 may expand over the entire area of the first surface 13. For example, the second adhesion layer 22 may include a portion that does not overlap the second metal layer 32 in a plan view, in addition to the portion positioned between the substrate 12 and the second metal layer 32. For example, the second adhesion layer 22 may expand over the entire area of the second surface 14. "Plan view" means looking at a target object in the normal direction of the first surface 13.

In this modification, the adhesion layer 20 has electrical insulation properties. For example, the adhesion layer 20 includes the metal oxide having electrical insulation properties. Since the adhesion layer 20 has electrical insulation properties, an electrical short circuit at the metal layer 30 is suppressed even when the adhesion layer 20 includes a portion that does not overlap the metal layer 30.

When the adhesion layer removal step is not performed, the through-via substrate 10 shown in Figs. 18A and 18B is obtained. According to this modification, the adhesion layer removal step is unnecessary, so the manufacturing cost of the through-via substrate 10 is reduced.

### (Eighth Modification)

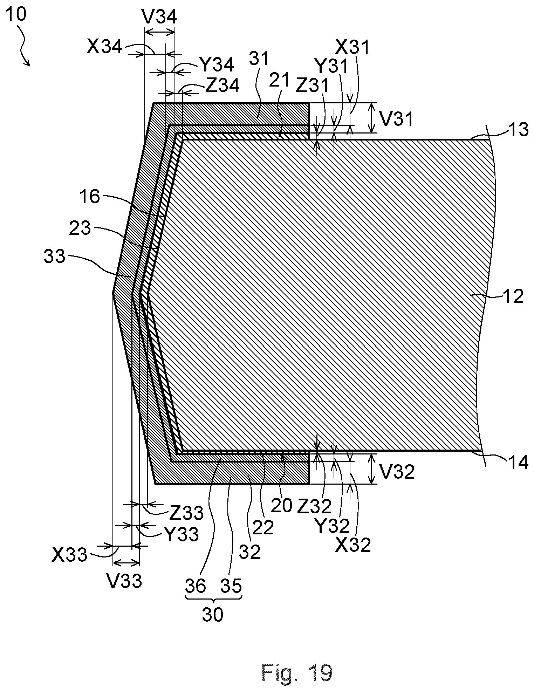

Fig. 19 is a sectional view showing a through-via substrate 10 in the eighth modification. The thickness Z32 of the second adhesion layer 22 on the second surface 14 may be different from the thickness Z31 of the first adhesion layer 21 on the first surface 13. For example, the thickness Z32 of the second adhesion layer 22 may be less than the thickness Z31 of the first adhesion layer 21. The difference in thickness is implemented by forming the second adhesion layer 22 through a step separate from a step of forming the first adhesion layer 21. For example, the step of forming the first adhesion layer 21 is performed in a state where the second surface 14 is covered, and the step of forming the second adhesion layer 22 is performed in a state where the first surface 13 is covered. In this case, the difference in thickness is implemented by adjusting the conditions of the two steps. The two steps both may be an atomic layer deposition step.

Z32/Z31, which is the ratio of the thickness Z32 of the second adhesion layer 22 to the thickness Z31 of the first adhesion layer 21, is, for example, greater than or equal to 0.01, may be greater than or equal to 0.10, or may be greater than or equal to 0.30. Z32/Z31 is, for example, less than or equal to 0.90, may be less than or equal to 0.80, or may be less than or equal to 0.60.

Although not illustrated, the thickness Z32 of the second adhesion layer 22 may be greater than the thickness Z31 of the first adhesion layer 21. In this case, Z31/Z32, which is the ratio of the thickness Z31 of the first adhesion layer 21 to the thickness Z32 of the second adhesion layer 22, is, for example, greater than or equal to 0.01, may be greater than or equal to 0.10, or may be greater than or equal to 0.30. Z31/Z32 is, for example, less than or equal to 0.90, may be less than or equal to 0.80, or may be less than or equal to 0.60.

### (Ninth Modification)

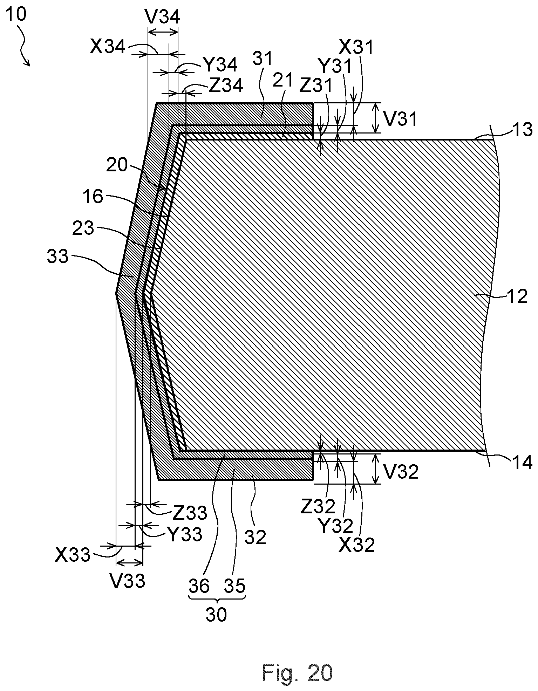

Fig. 20 is a sectional view showing a through-via substrate 10 in the ninth modification. The adhesion layer 20 includes the first adhesion layer 21 on the first surface 13 and the hole adhesion layer 23 on the side wall 16; however, the adhesion layer 20 does not need to include the second adhesion layer 22 on the second surface 14. The through-via substrate 10 shown in Fig. 20 is obtained by, for example, performing the atomic layer deposition step in a state where the second surface 14 is covered.

Although not illustrated, the adhesion layer 20 includes the second adhesion layer 22 on the second surface 14 and the hole adhesion layer 23 on the side wall 16; however, the adhesion layer 20 does not need to include the first adhesion layer 21 on the first surface 13.

### (Tenth Modification)

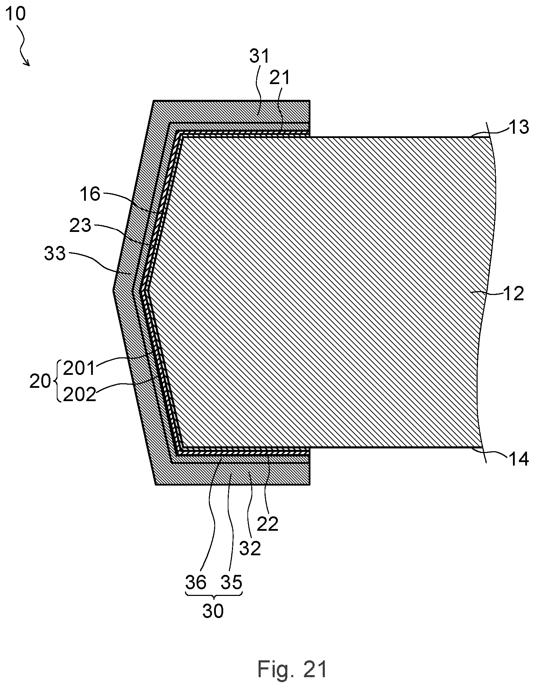

Fig. 21 is a sectional view showing a through-via substrate 10 in the tenth modification. The adhesion layer 20 may include a plurality of layers. For example, the adhesion layer 20 may include a lower adhesion layer 201 and an upper adhesion layer 202, as shown in Fig. 21.

The lower adhesion layer 201 may be in contact with the substrate 12. For example, the lower adhesion layer 201 of the first adhesion layer 21 may be in contact with the first surface 13, the lower adhesion layer 201 of the second adhesion layer 22 may be in contact with the second surface 14, and the lower adhesion layer 201 of the hole adhesion layer 23 may be in contact with the side wall 16.

The upper adhesion layer 202 may be in contact with the metal layer 30. For example, the upper adhesion layer 202 of the first adhesion layer 21 may be in contact with the first metal layer 31, the upper adhesion layer 202 of the second adhesion layer 22 may be in contact with the second metal layer 32, and the upper adhesion layer 202 of the hole adhesion layer 23 may be in contact with the hole metal layer 33.

The upper adhesion layer 202 may be in contact with the lower adhesion layer 201. Although not illustrated, the adhesion layer 20 may include an intermediate adhesion layer positioned between the lower adhesion layer 201 and the upper adhesion layer 202.

The metal oxide included in the upper adhesion layer 202 and the metal oxide included in the lower adhesion layer 201 may be different from each other. By using different metal oxides, the upper adhesion layer 202 and the lower adhesion layer 201 can perform different functions.

The lower adhesion layer 201 is a layer for suppressing the peeling of the adhesion layer 20 from the substrate 12. Preferably, the lower adhesion layer 201 has a higher adhesion to the substrate 12 than the upper adhesion layer 202. For example, the peel strength of the lower adhesion layer 201 to the substrate 12 is higher than the peel strength of the upper adhesion layer 202 to the substrate 12.

The upper adhesion layer 202 is a layer for performing at least one of a first function and a second function.

The first function is a function to suppress the peeling of the metal layer 30 from the adhesion layer 20. When the upper adhesion layer 202 has the first function, the upper adhesion layer 202 has a higher adhesion to the metal layer 30 than the lower adhesion layer 201. For example, the peel strength of the metal layer 30 to the upper adhesion layer 202 is higher than the peel strength of the metal layer 30 to the lower adhesion layer 201.

The second function is a function to suppress the dissolution of the adhesion layer 20 into drugs. When the upper adhesion layer 202 has the second function, the upper adhesion layer 202 has a higher resistance to drugs, such as acidic solutions, than the lower adhesion layer 201. For example, the upper adhesion layer 202 passes a drug test (described later); however, the lower adhesion layer 201 fails the drug test.

In the drug test, a sample including the adhesion layer 20 that includes the lower adhesion layer 201 and the upper adhesion layer 202 is immersed in a test solution. The test solution is a solution that simulates an etchant for etching a copper layer. The test solution is 5% hydrogen peroxide and 5% sulfuric acid. In the drug test, the sample is immersed in the test solution at room temperature (25°C) for five minutes. When the layer remains after the five minutes of immersion, the layer is determined to have passed. When the layer dissolves to disappear during the five minutes of immersion, the layer is determined to have failed. The upper adhesion layer 202 may be defined as a layer that can pass the drug test. The lower adhesion layer 201 may be defined as a layer that fails the drug test.

The lower adhesion layer 201 includes metal oxide having an adhesion to the substrate 12. For example, when the substrate 12 includes glass, the lower adhesion layer 201 may include metal oxide, such as zinc oxide, aluminum oxide, and hafnium oxide.

Aluminum oxide and hafnium oxide have an adhesion to glass; however, aluminum oxide and hafnium oxide have a poor adhesion to metals, such as copper. When the lower adhesion layer 201 includes aluminum oxide or hafnium oxide, the upper adhesion layer 202 preferably has the first function. The upper adhesion layer 202 having the first function may include metal oxide, such as titanium oxide and tantalum oxide. Examples of combinations of materials that compose the lower adhesion layer 201 and the upper adhesion layer 202 are shown below.

(Lower adhesion layer 201, Upper adhesion layer 202) = (Al₂O₃, TiO₂), (HfO₂, TiO₂), (Al₂O₃, Ta₂O₅), (HfO₂, Ta₂O₅)

Zinc oxide and magnesium oxide have an adhesion to glass; however, zinc oxide and magnesium oxide have a poor resistance to drugs. When the lower adhesion layer 201 includes zinc oxide or magnesium oxide, the upper adhesion layer 202 preferably has the second function. The upper adhesion layer 202 having the second function may include metal oxide, such as titanium oxide and tantalum oxide.

(Lower adhesion layer 201, Upper adhesion layer 202) = (ZnO, TiO₂), (MgO, TiO₂), (ZnO, Ta₂O₅), (MgO, Ta₂O₅)

The lower adhesion layer 201 and the upper adhesion layer 202 both may be formed by atomic layer deposition.

The thickness of the upper adhesion layer 202 may be the same as the thickness of the lower adhesion layer 201 or may be different from the thickness of the lower adhesion layer 201.

### (Eleventh Modification)

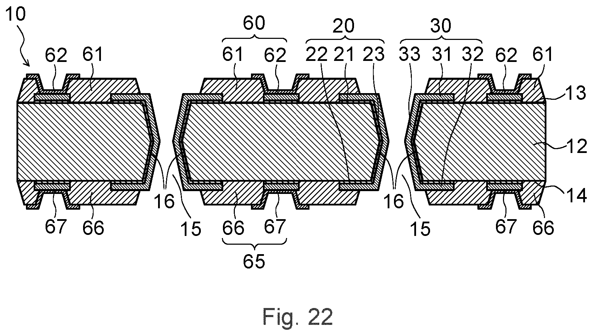

Fig. 22 is a sectional view showing a through-via substrate 10 in the eleventh modification. The through-via substrate 10 may include a first wiring layer 60 positioned on the first surface 13. The first wiring layer 60 includes a first insulating layer 61 and a first conductive layer 62. The first insulating layer 61 may partially cover the first metal layer 31. The first insulating layer 61 may expand in the in-plane direction between adjacent two first metal layers 31 in the in-plane direction of the first surface 13. The first conductive layer 62 may be connected to the first metal layer 31. Part of the first conductive layer 62 may be positioned on the first insulating layer 61.

The first insulating layer 61 includes a material having electrical insulation properties. The first insulating layer 61 may include an organic material or may include an inorganic material. The first insulating layer 61 may include an organic layer including an organic material and an inorganic layer including an inorganic material. The organic layer and the inorganic layer may overlap in the thickness direction. Examples of the organic material include polyimide. Examples of the inorganic material include silicon oxide and silicon nitride.

The first conductive layer 62 includes a material having electrical conductivity. The first conductive layer 62 may include a metal material. Examples of the metal material of the first conductive layer 62 include metals such as copper, aluminum, nickel, gold, and tungsten, and alloys of these metals.

The first wiring layer 60 may include two or more first insulating layers 61 and two or more first conductive layers 62 that are alternately laminated in the thickness direction.

As shown in Fig. 22, the through-via substrate 10 may include a second wiring layer 65 positioned on the second surface 14. The second wiring layer 65 includes a second insulating layer 66 and a second conductive layer 67. The second insulating layer 66 may partially cover the second metal layer 32. The second insulating layer 66 may expand in the in-plane direction between adjacent two second metal layers 32 in the in-plane direction of the second surface 14. The second conductive layer 67 may be connected to the second metal layer 32. Part of the second conductive layer 67 may be positioned on the second insulating layer 66.

The second insulating layer 66 includes a material having electrical insulation properties, similar to the first insulating layer 61. The second insulating layer 66 may include an organic material or may include an inorganic material. The second insulating layer 66 may include an organic layer including an organic material and an inorganic layer including an inorganic material. The organic layer and the inorganic layer may overlap in the thickness direction. Examples of the organic material include polyimide. Examples of the inorganic material include silicon oxide and silicon nitride.

The second conductive layer 67 includes a material having electrical conductivity. The second conductive layer 67 may include a metal material. Examples of the metal material of the second conductive layer 67 include metals such as copper, aluminum, nickel, gold, and tungsten, and alloys of these metals.

The second wiring layer 65 may include two or more second insulating layers 66 and two or more second conductive layers 67 that are alternately laminated in the thickness direction.

The through-via substrate 10 may constitute a passive component. For example, the first metal layer 31, the first insulating layer 61, and the first conductive layer 62 may constitute a capacitor. For example, the second metal layer 32, the second insulating layer 66, and the second conductive layer 67 may constitute a capacitor. For example, the first metal layer 31, the second metal layer 32, and the hole metal layer 33 may constitute an inductor.

The through-via substrate 10 may include a semiconductor element. The semiconductor element may have a terminal that is electrically connected to the first conductive layer 62 of the first wiring layer 60. The through-via substrate 10 including a semiconductor element is also referred to as a semiconductor substrate.

The through-via substrate 10 may include a sensor. The through-via substrate 10 including a sensor is also referred to as a sensor substrate.

The through-via substrate 10 may include an optical component. The optical component may be a component that emits light or a component that receives light. The through-via substrate 10 including an optical component is also referred to as an optical substrate.

The through-via substrate 10 may include a high-frequency component. The high-frequency component may be a component that transmits high-frequency signals or a component that receives high-frequency signals. The through-via substrate 10 including a high-frequency component is also referred to as a high-frequency substrate.

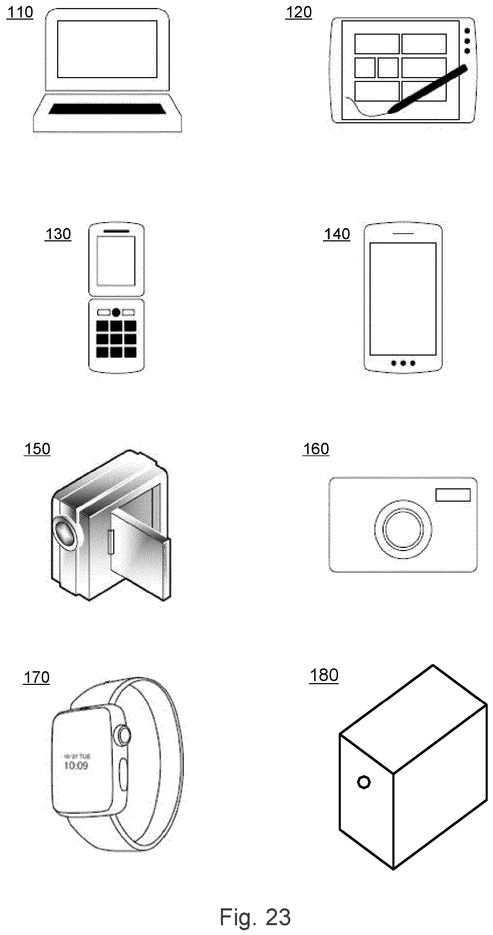

Fig. 23 is a diagram showing examples of a product to which the through-via substrate 10 is mounted. The through-via substrate 10 can be used in various products. The through-via substrate 10 is mounted to, for example, a notebook personal computer 110, a tablet terminal 120, a mobile phone 130, a smartphone 140, a digital video camera 150, a digital camera 160, a digital clock 170, a server 180, or the like.

Some modifications to the above-described embodiment have been described; of course, it is also possible to apply a plurality of modifications in combination as needed to the above-described embodiment.

### EXAMPLES

Next, the embodiment of the present disclosure will be further specifically described by way of examples. The embodiment of the present disclosure is not limited to the following examples without departing from the scope of the present disclosure.

### (Example 1)

A glass substrate having a thickness of 380 µm was prepared as a substrate 12. Subsequently, a through hole 15 having a diameter of 50 µm was formed in the substrate 12. Subsequently, an adhesion layer 20 including zinc oxide was formed on the surface of the substrate 12 by atomic layer deposition. The thickness of the adhesion layer 20 was 10 nm. The deposition temperature of the adhesion layer 20 was higher than or equal to 100°C and lower than or equal to 250°C.

Subsequently, the annealing step of heating the adhesion layer 20 was performed. The temperature of the annealing step was higher than or equal to 500°C.

Subsequently, an intermediate layer 36 including copper was formed on the adhesion layer 20 by electroless plating. Subsequently, the intermediate layer annealing step of heating the intermediate layer 36 was performed. The temperature of the intermediate layer annealing step was 250°C.

Subsequently, a body layer 35 including copper was formed on the intermediate layer 36 by electrolytic plating. Subsequently, the body layer annealing step of heating the body layer 35 was performed. The temperature of the body layer annealing step was higher than or equal to 350°C. In this way, the through-via substrate 10 was manufactured.

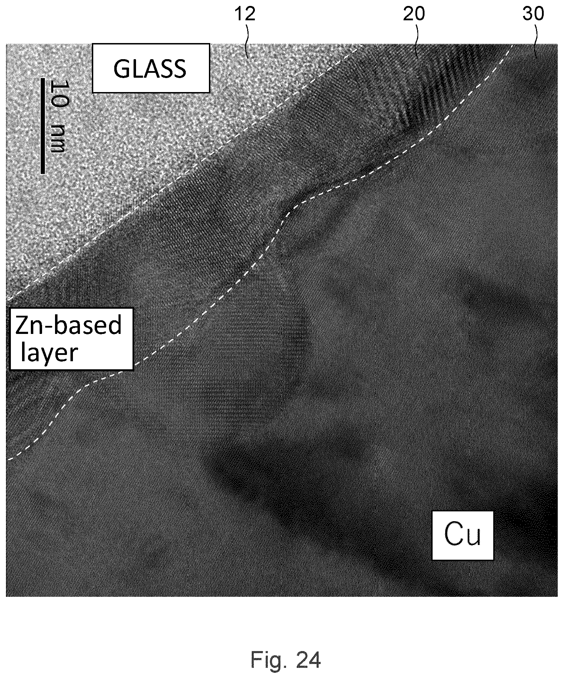

A hole adhesion layer 23 and a hole metal layer 33 formed on a side wall 16 of the through hole 15 were observed by using a transmission electron microscope. The obtained image is shown in Fig. 24. In Fig. 24, the white dashed line is drawn at the boundary between the hole adhesion layer 23 and the hole metal layer 33.

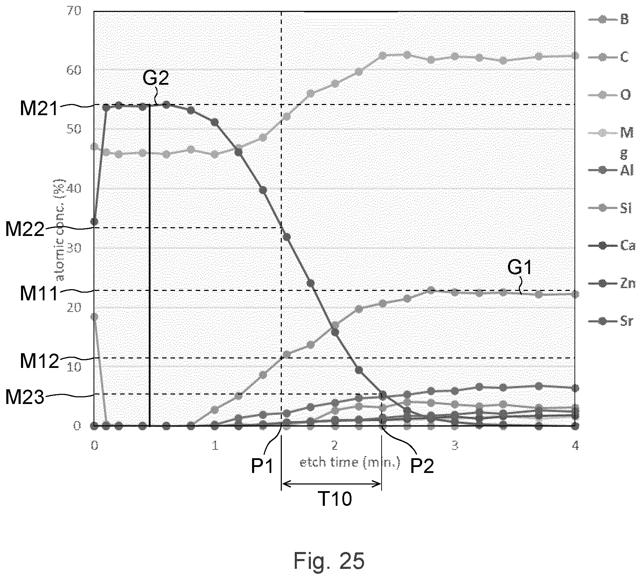

In addition to observations using a transmission electron microscope, the composition of the sample including the substrate 12 and the adhesion layer 20 was analyzed by X-ray photoelectron spectroscopy after the intermediate layer annealing step and before the body layer formation step. Fig. 25 is a graph showing the analysis results. A scanning X-ray photoelectron spectrometer PHI 5000 VersaProbelll made by PHI was used as an analyzer.

The spectrum acquisition conditions were as follows.
Incident X-ray: Al Kα (monochromatic X-ray, hv = 1486.6 eV)
X-ray output: 50 W (15 kV, 3.3 mA)
X-ray beam diameter: 200 µm
X-ray scanning area (surface XPS): 600 µm × 300 µm
X-ray scanning area (depth profiling XPS): no scanning
Photoelectron take-off angle: 45 degrees
Charge neutralization: Electron neutralization gun, low-acceleration Ar⁺ ion irradiation
The conditions for ion sputter etching were as follows.
Ionic species: Ar⁺ (2.0 keV)
Acceleration voltage: 2.0 kV
Emission current: 7.0 mA
Etching range (the raster range of the ion beam): 2 mm × 2 mm
Etching rate (in SiO₂ equivalent): 6 nm/min
Rotation of the sample: Not performed

In Fig. 25, the abscissa axis represents the ion sputter etching time, and the ordinate axis represents the atomic concentrations of the detected elements. Reference sign G1 represents the spectrum of silicon. Reference sign G2 represents the spectrum of zinc. Reference sign P1 represents the boundary position. The boundary position P1 is the position where the atomic concentration of silicon that is the main component of the substrate 12 becomes 50% of the maximum atomic concentration M11. In other words, the atomic concentration M12 of silicon at the boundary position P1 is 50% of the maximum atomic concentration M11.

Reference sign M21 represents the maximum atomic concentration of zinc that is the metal constituting the metal oxide of the adhesion layer 20. Reference sign M22 represents the atomic concentration at the boundary position P1, of zinc that is the metal constituting the metal oxide of the adhesion layer 20. As shown in Fig. 25, M22/M21, which is the ratio of the atomic concentration M22 at the boundary position P1 to the maximum atomic concentration M21, was greater than or equal to 0.50. The surface layer of the substrate 12 is determined to include a metal that constitutes the metal oxide of the adhesion layer 20.

The surface layer including a metal that constitutes the metal oxide of the adhesion layer 20 has a thickness T10. The thickness T10 is a distance from the boundary position P1 to the inner boundary position P2 in the thickness direction of the substrate 12. The inner boundary position P2 is the position where the concentration M23 of metal constituting the metal oxide of the adhesion layer 20 is 0.10 times the maximum atomic concentration M21.

The thickness T10 is calculated by converting the difference in ion sputter etching time between the boundary position P1 and the inner boundary position P2 into a distance based on the etching rate. In Example 1, the thickness T10 was 4.9 nm.

### (Example 2)

A glass substrate having a thickness of 380 µm was prepared as a substrate 12. Subsequently, a through hole 15 having a diameter of 50 µm was formed in the substrate 12. Subsequently, an adhesion layer 20 including titanium oxide was formed on the surface of the substrate 12 by atomic layer deposition. The thickness of the adhesion layer 20 was 10 nm.

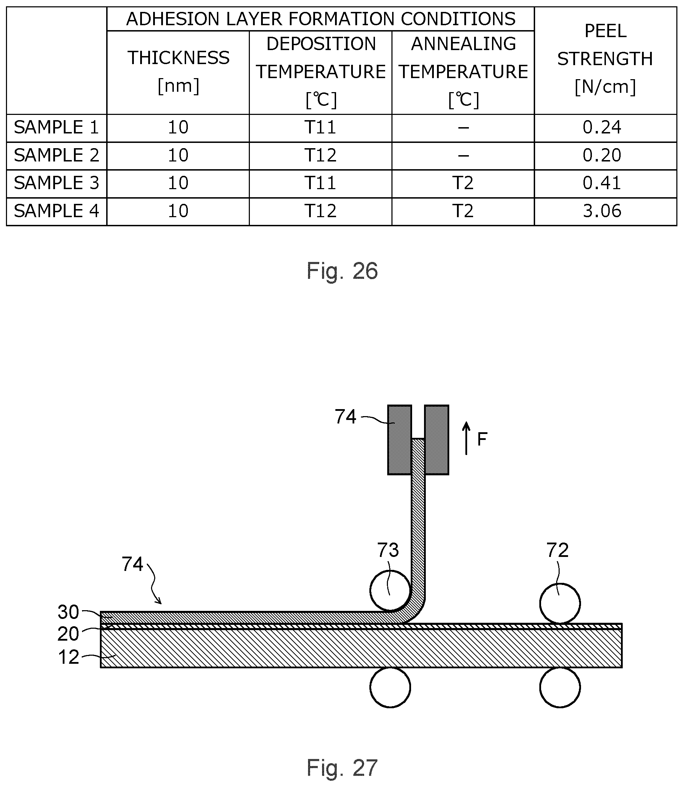

The deposition temperature of the adhesion layer 20 was T11 or T12. The temperature T11 and the temperature T12 both fall within the range higher than or equal to 100°C and lower than or equal to 250°C. The temperature T12 is higher than the temperature T11. As shown in Fig. 26, in samples 1 and 3, the deposition temperature of the adhesion layer 20 was T11. In samples 2 and 4, the deposition temperature of the adhesion layer 20 was T12.

Subsequently, the annealing step of heating the adhesion layer 20 was performed in samples 3 and 4. The temperature T2 of the annealing step was higher than 250°C.

Subsequently, an intermediate layer 36 including copper was formed on the adhesion layer 20 by electroless plating. Subsequently, the intermediate layer annealing step of heating the intermediate layer 36 was performed. The temperature of the intermediate layer annealing step was 250°C.

Subsequently, a body layer 35 including copper was formed on the intermediate layer 36 by electrolytic plating. Subsequently, the body layer annealing step of heating the body layer 35 was performed. The temperature of the body layer annealing step was higher than or equal to 350°C. In this way, the through-via substrate 10 was manufactured. The thickness of the metal layer 30 that includes the body layer 35 and the intermediate layer 36 was 20 µm.

Subsequently, the peeling test for the metal layers 30 of samples 1 to 4 was performed in accordance with JIS K 6854-1. Fig. 27 is a diagram showing a method for the peeling test. The peeling test was performed in an environment of 25°C. Samples 1 to 4 have a rectangular outline with 10-mm short sides in a plan view.

As shown in Fig. 27, part of the metal layer 30 was peeled off from the adhesion layer 20. The adhesion layer 20 and the substrate 12 that had been overlapping the peeled metal layer 30 were supported by first support rollers 72. Second support rollers 73 and a clamp 74 were adjusted so that the peeled metal layer 30 and the metal layer 30 on the adhesion layer 20 form an angle of 90 degrees.

While the angle of 90 degrees was maintained, the clamp 74 was moved upward by 50 mm. The average value of the load applied to the clamp 74 during the movement was calculated as the peel strength of the metal layer 30. The results are shown in Fig. 26.

As shown in Fig. 26, in samples 3 to 4 for which the annealing step was performed, the peel strength was greater than or equal to 0.40 N/10mm. Particularly, in sample 4 of which the deposition temperature was T12, the peel strength was greater than or equal to 3.00 N/10mm. In samples 3 to 4, it is presumable that metal oxide in a crystalline state is at least partially formed in the adhesion layer 20 through the annealing step. On the other hand, in samples 1 to 2, it is presumable that metal oxide in an amorphous state occupies a major part of the adhesion layer 20.

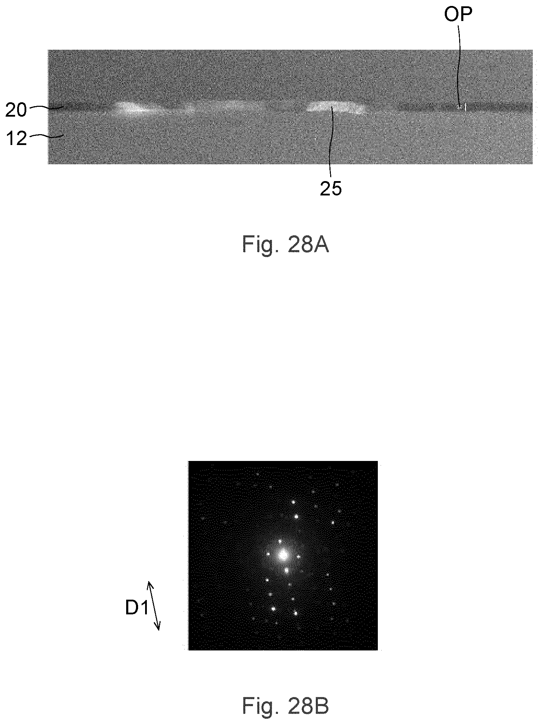

Fig. 28A shows an image obtained by observing the adhesion layer 20 including metal oxide in a crystalline state by using a transmission electron microscope (TEM). The white part indicated by reference sign 25 in Fig. 28A represents titanium oxide in a crystalline state.

Fig. 28B shows the electron diffraction pattern of the adhesion layer 20 including metal oxide in a crystalline state. The electron diffraction pattern shown in Fig. 28B is the analysis result of the area indicated by reference sign OP in Fig. 28A. As shown in Fig. 28B, a plurality of diffraction spots regularly arranged in the direction D1 was observed. The conditions for measuring the electron diffraction pattern were as follows.
· Diffractometry: Micro electron diffraction method
· Apparatus: Transmission electron microscope JEM-ARM200F made by JEOL Ltd.
· Acceleration voltage: 200 kV
· Camera length: 0.8 m
· Beam diameter: 1 nm

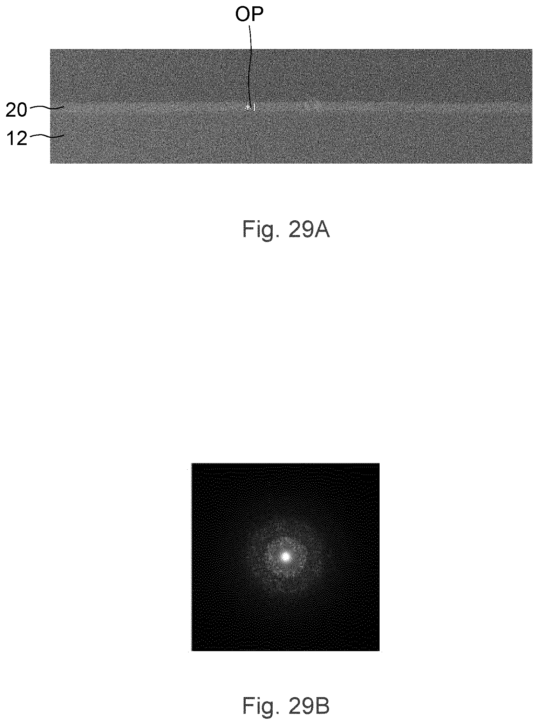

Fig. 29A shows an image obtained by observing the adhesion layer 20 not including a metal oxide in a crystalline state by using a transmission electron microscope.

Fig. 29B shows the electron diffraction pattern of the adhesion layer 20 not including a metal oxide in a crystalline state. The electron diffraction pattern shown in Fig. 29B is the analysis result of the area indicated by reference sign OP in Fig. 29A. As shown in Fig. 29B, a plurality of diffraction spots regularly arranged was not observed.

### Reference Signs List

10 through-via substrate
12 substrate
13 first surface
14 second surface
15 through hole
16 side wall
161 first end
162 second end
20 adhesion layer
201 lower adhesion layer
202 upper adhesion layer
21 first adhesion layer
22 second adhesion layer
23 hole adhesion layer
30 metal layer
31 first metal layer
32 second metal layer
33 hole metal layer
331 closed portion
35 body layer
36 intermediate layer
41 first resist layer
42 second resist layer
50 deposition apparatus
51 chamber
60 first wiring layer
61 first insulating layer
62 first conductive layer
65 second wiring layer
66 second insulating layer
67 second conductive layer
71 sample
72 first support roller
73 second support roller
74 clamp

## Claims

1. A through-via substrate comprising:
a substrate that includes a first surface, a second surface positioned on an opposite side from the first surface, and a through hole penetrating from the first surface to the second surface;
a metal layer including at least a hole metal layer positioned in the through hole; and
an adhesion layer positioned between the substrate and the metal layer, the adhesion layer including a metal oxide, wherein
the through hole includes a side wall extending from the first surface to the second surface,
the side wall includes a first end connected to the first surface and a second end connected to the second surface, and
the adhesion layer includes a hole adhesion layer positioned between the side wall and the hole metal layer so as to extend from the first end of the side wall to the second end of the side wall.

2. The through-via substrate according to claim 1, wherein
the through hole has an aspect ratio of 3.0 or greater, and
the aspect ratio is a ratio of a thickness of the substrate to a minimum value of a width of the through hole.

3. The through-via substrate according to claim 1, wherein the metal oxide is titanium oxide, zinc oxide, aluminum oxide, tantalum oxide, or magnesium oxide.

4. The through-via substrate according to claim 1, wherein the adhesion layer includes the metal oxide in a crystalline state.

5. The through-via substrate according to claim 1, wherein an electron diffraction pattern of the metal oxide of the adhesion layer includes a plurality of diffraction spots regularly arranged in at least one direction.

6. The through-via substrate according to claim 1, wherein
the hole adhesion layer has a central thickness at a central position in a thickness direction of the substrate and has an edge thickness at a position of the first surface of the substrate, and
a ratio of the edge thickness to the central thickness is 1.10 or less.

7. The through-via substrate according to claim 1, wherein the adhesion layer includes a lower adhesion layer that is in contact with the substrate and an upper adhesion layer that is in contact with the metal layer.

8. The through-via substrate according to claim 7, wherein the metal oxide included in the lower adhesion layer and the metal oxide included in the upper adhesion layer are different from each other.

9. The through-via substrate according to any one of claims 1 to 8, wherein
the substrate includes a surface layer that constitutes a surface of the side wall, and
the surface layer includes metal atoms that are the same as metal atoms that constitute the metal oxide of the adhesion layer.

10. The through-via substrate according to any one of claims 1 to 8, wherein the metal layer includes copper, aluminum, nickel, gold, or tungsten.

11. The through-via substrate according to any one of claims 1 to 8, wherein the metal layer includes a body layer and an intermediate layer, the body layer includes a metal material, the intermediate layer is positioned between the body layer and the adhesion layer, and the intermediate layer includes a metal material, and the intermediate layer is thinner than the body layer.

12. The through-via substrate according to claim 11, wherein the body layer and the intermediate layer include the same metal material.

13. The through-via substrate according to any one of claims 1 to 8, wherein
the adhesion layer includes a first adhesion layer positioned on the first surface, and
the metal layer includes a first metal layer positioned on the first adhesion layer.

14. The through-via substrate according to claim 13, wherein
the hole metal layer has a central thickness at a central position in a thickness direction of the substrate, and
a ratio of a thickness of the first metal layer to the central thickness of the hole metal layer is 1.50 or less.

15. The through-via substrate according to claim 13, further comprising a first wiring layer that includes a first insulating layer partially covering the first metal layer and a first conductive layer connected to the first metal layer.

16. The through-via substrate according to claim 15, wherein the first conductive layer includes copper, aluminum, nickel, gold, or tungsten.

17. The through-via substrate according to claim 15, wherein the first insulating layer includes silicon oxide, silicon nitride, or polyimide.

18. The through-via substrate according to claim 13, wherein
the adhesion layer includes a second adhesion layer positioned on the second surface, and
the metal layer includes a second metal layer positioned on the second adhesion layer.

19. The through-via substrate according to claim 18, further comprising a second wiring layer that includes a second insulating layer partially covering the second metal layer and a second conductive layer connected to the second metal layer.

20. The through-via substrate according to any one of claims 1 to 8, further comprising a semiconductor element, a sensor, an optical component, or a high-frequency component.

21. A manufacturing method for a through-via substrate, the manufacturing method comprising:
a preparation step of preparing a substrate that includes a first surface, a second surface positioned on an opposite side from the first surface, and a through hole penetrating from the first surface to the second surface;
an adhesion layer formation step of forming an adhesion layer on a surface of the substrate; and
a metal layer formation step of forming a metal layer on the adhesion layer, wherein
the through hole includes a side wall extending from the first surface to the second surface,
the side wall includes a first end connected to the first surface and a second end connected to the second surface,
the adhesion layer formation step includes a deposition step of forming a hole adhesion layer by chemical vapor deposition, the hole adhesion layer being positioned between the side wall and the metal layer so as to extend from the first end of the side wall to the second end of the side wall, and
the metal layer formation step includes a step of forming a hole metal layer on the hole adhesion layer, the hole metal layer being positioned in the through hole.

22. The manufacturing method for a through-via substrate according to claim 21, wherein the metal layer formation step includes a step of forming an intermediate layer on the adhesion layer by electroless plating and a step of forming a body layer on the intermediate layer by electrolytic plating.

23. The manufacturing method for a through-via substrate according to claim 21, wherein the deposition step is performed in an environment of 100°C or higher.

24. The manufacturing method for a through-via substrate according to any one of claims 21 to 23, wherein the adhesion layer formation step includes an annealing step of, after the deposition step, heating the adhesion layer at a temperature higher than a temperature of the deposition step.

25. The manufacturing method for a through-via substrate according to any one of claims 21 to 23, wherein the preparation step includes a through hole formation step of forming the through hole in the substrate.

26. A substrate used in the manufacturing method for a through-via substrate according to any one of claims 21 to 23, wherein
the substrate comprises a first surface, a second surface positioned on an opposite side from the first surface, and a through hole penetrating from the first surface to the second surface,
the through hole includes a side wall extending from the first surface to the second surface, and the side wall includes a first end connected to the first surface and a second end connected to the second surface.
